(19) Europäisches Patentamt
European Patent Office
Office européen des brevets

(11) **EP 3 743 237 B1**

(12) **FASCICULE DE BREVET EUROPEEN**

(45) Date de publication et mention de la délivrance du brevet:
**29.11.2023 Bulletin 2023/48**

(21) Numéro de dépôt: **19707269.7**

(22) Date de dépôt: **25.01.2019**

(51) Classification Internationale des Brevets (IPC):
**B23K 26/00** *(2014.01)*  **B23K 26/06** *(2014.01)*
**G09B 19/24** *(2006.01)*  **B23K 26/70** *(2014.01)*
**B23K 26/60** *(2014.01)*

(52) Classification Coopérative des Brevets (CPC):
**B23K 26/0626; B23K 26/00; B23K 26/60;**
**B23K 26/702; G06F 30/00; G06F 30/20;**
**G09B 19/24**

(86) Numéro de dépôt international:
**PCT/EP2019/051916**

(87) Numéro de publication internationale:
**WO 2019/145515 (01.08.2019 Gazette 2019/31)**

(54) **METHODE POUR LA SIMULATION D'USINAGES LASER, SYSTEME D'USINAGE LASER AYANT DES MOYENS POUR METTRE EN OEUVRE LADITE METHODE, ET PROGRAMME D'ORDINATEUR POUR IMPLEMENTER UNE TELLE METHODE**

LASERBEARBEITUNGS-SIMULATIONSVERFAHREN, LASERBEARBEITUNGSSYSTEM MIT MITTEL ZUR DURCHFÜHRUNG DES VERFAHRENS, UND COMPUTERPROGRAMM ZUR DURCHFÜHRUNG DIESES VERFAHRENS

LASER MACHINING SIMULATION METHOD, LASER MACHINING SYSTEM WITH MEANS FOR PUT IN PRACTICE SUCH METHOD, AND CORRESPONDING COMPUTER PROGRAM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.01.2018 BE 201805046**

(43) Date de publication de la demande:
**02.12.2020 Bulletin 2020/49**

(73) Titulaire: **Laser Engineering Applications**
**4102 Seraing (BE)**

(72) Inventeurs:
• BRUNEEL, David
  4920 Sougné-Remouchamps (BE)
• CANGUEIRO, Liliana
  3000 Leuven (BE)
• MARTIN, Paul-Etienne
  33000 Bordeaux (FR)
• RAMOS DE CAMPOS, Jose-Antonio
  4031 Angleur (BE)
• KUPISIEWICZ, Axel
  4122 Neupré (BE)

(74) Mandataire: **Gevers Patents**
**Intellectual Property House**
**Holidaystraat 5**
**1831 Diegem (BE)**

(56) Documents cités:
WO-A1-2011/083087    WO-A1-2015/113302
US-A1- 2016 078 156    US-A1- 2017 032 281

**EP 3 743 237 B1**

**Description**

Selon un premier aspect, l'invention se rapporte à une méthode pour la simulation d'usinages laser d'un matériau. Selon un deuxième aspect, l'invention se rapporte à un dispositif d'usinage laser, un programme d'ordinateur, et un support de données lisible par ordinateur portant un tel programme.

**Etat de la technique**

Les faisceaux lasers sont notamment utilisés pour l'usinage de pièces. Il est en effet possible de fondre, d'évaporer ou de sublimer une partie d'un matériau exposé à un faisceau laser. L'usinage de pièces avec des faisceaux lasers permet la réalisation de découpes, de trous, de rainures, de texturation de surface par exemple avec une très grande efficacité.

Les dispositifs d'usinage laser utilisent de plus en plus des impulsions de faisceaux lasers ayant une durée inférieure à la ns et ayant une grande énergie par impulsion, de l'ordre du J/cm$^2$. Il est nécessaire de définir, de paramétrer le dispositif d'usinage laser de sorte à obtenir un usinage cible que l'on souhaite réaliser. Il est alors nécessaire de définir les paramètres d'usinage laser pour tout usinage cible nouvellement défini ainsi que pour tout nouveau matériau.

Pour la réalisation d'un nouvel usinage cible et/ou l'utilisation d'un nouveau matériau, il est nécessaire de réaliser des expériences d'usinage préalables de sorte à définir les paramètres d'usinage laser qui permettront d'atteindre l'usinage cible pour le matériau choisi. Un grand nombre d'expériences préalable est souvent nécessaire ce qui requiert une utilisation prolongée d'un dispositif d'usinage laser par un opérateur, ainsi que de nombreux échantillons de matériaux. WO2015/113302 (décrivant l'ensemble des caractéristiques du préambule des revendications 1 et 13) divulgue un système et un procédé de simulation d'une machine de forage laser et d'une machine de forage laser équipée du système de simulation. US2016/078156 décrit un procédé d'exécution d'un modèle de simulation tout en générant un modèle structurel associé. Le procédé comprend la modification du modèle structurel, l'évaluation d'au moins un critère de déclenchement pour déterminer si la modification du modèle structurel est un événement déclencheur de simulation, et l'exécution du modèle de simulation si le changement au modèle structurel est déterminé comme étant l'événement déclencheur de la simulation. WO2011/083087 propose une méthode pour usiner des pièces au moyen d'un processus cognitif reposant sur une itération de l'apprentissage. La méthode comprend une première phase d'apprentissage à l'aide d'une personne experte puis une étape d'apprentissage sans supervision ou de prise de décision seul.

Un problème technique à résoudre est de disposer d'une méthode permettant de définir des paramètres d'usinage laser sans l'utilisation d'un dispositif d'usinage laser ainsi que de nombreux échantillons de matériaux et leur caractérisation. En particulier, il serait utile de pouvoir prédire les résultats d'un usinage laser, sans devoir utiliser un système d'usinage laser.

**Résumé de l'invention**

Selon un premier aspect, un des buts de la présente invention est de fournir une méthode permettant une simulation fiable d'un usinage laser sur la base de paramètres d'usinage laser.

Une méthode pour la simulation d'un usinage laser par irradiation multi-impulsionnelle d'un matériau par un système d'usinage laser apte à émettre un faisceau laser d'usinage selon un premier aspect de la présente invention est définie dans la revendication 1.

La méthode de simulation selon l'invention permet de résoudre le problème technique grâce, en particulier, à la bonne prise en compte de l'intéraction laser-matière, et à son implémentation dans ladite méthode de simulation. La méthode de simulation de l'invention propose une approche numérique pour la simulation de phénomènes pysiques complexes de sorte à obtenir des résultats de simulation très proches des résultats expérimentaux obtenus avec les mêmes paramètres d'usinage laser. En effet, les outils de simulation de l'état de la technique utilisent une aproche analytique de sorte que la résolution des modèles analytiques est très souvent très demandeuse en terme de capacité de calcul ainsi qu'elle ne permet pas certaines simulations, par exemple lorsqu'une simulation présente un faisceau laser incident ayant une incidence qui n'est pas normale à la surface du matériau.

La méthode de l'invention permet la détermination de paramètres d'usinage et de préférence de paramètre d'usinage optimaux permettant d'usiner une pièce selon un usinage cible le plus fidèlement possible. Une telle méthode permet de garantir une bonne qualité d'usinage sans pour autant nécessiter de recourir à de nombreux et coûteux ajustements de paramètres d'usinage. En effet la méthode proposée par l'invention permet la prise en compte des paramètres physiques d'interaction entre le faisceau laser et le matériau à usiner lors de l'usinage, lors de précédentes expériences d'usinage ou encore à partir d'une base de données comprenant des informations relatives à une source laser ou à un matériau à usiner. De préférence, la méthode de l'invention prévoit de fournir avant l'étape a), une étape de fournir une unité centrale.

Les inventeurs ont observé de façon surprenante que la prise en compte par l'unité de contrôle des quatre paramètres matériaux en relation avec l'usinage laser (delta, fluence seuil, coefficient d'incubation, indice de réfraction complexe, permet d'obtenir des simulations d'usinage très fidèles à un usinage à atteindre sans avoir recours à des expérimentations empiriques et pour des plages d'utilisation d'un dispositif d'usinage laser étendues.

Préférentiellement, les informations relatives au matériau à usiner sont des informations relative à l'intéraction du faisceau d'usinage laser avec ledit matériau à usiner. Préférentiellement, les informations relatives à la polarisation dudit faisceau laser d'usinageechoisi parmi un choix de polarisation polarisation P/S vertical ou horizontal. Préférentiellement, l'énergie d'impulsion du faisceau laser d'usinage Ep est exprimée en $\mu$J. Préférentiellement, le diamètre du faisceau laser d'usinage à un point focal w correspond à la taille du waist w. Préférentiellement, l'ordre d'une gaussienne dudit faisceau laser d'usinage est compris entre 1 et 10.

Selon un mode de réalisation préféré de l'invention, les paramètres matériaux sont enregistrés dans la base de données après une étape d'optimisation. L'étape d'optimisation des paramètres matériaux de la base de données comprend une comparaison des paramètres matériaux mesurés expérimentalement et des paramètres matériaux estimés sur la base d'un modèle analytique. La comparaison basée sur l'analyse du $R^2$ qui doit être compris entre 0.92 et 1 permet une optimisation d'un paramètre matériau de la base de données de sorte à minimiser les erreurs lors de la simulation du fait de la diminution des possibles erreurs sur les paramètres matériaux enregistrés dans la base de donnée. En particulier, l'étape de détermination du paramètre matériau delta $\delta$ se fait en réalisant une comparaison entre les mesures expérimentales et du modèle de la profondeur d'ablation en fonction de la fluence. La valeur du delta $\delta$ est déterminée après plusieurs itérations jusqu'à ce que la superpositon de ces deux courbes mesurée par le $R^2$ soit compris entre 0.92 et 1.

L'approche numérique de l'invention permet de simuler de façon successive l'arrivée de chaque impulsion du faisceau laser d'usinage sur la surface du matériau. La topologie de la surface du matériau étant mise à jour avant l'impulsion suivante. Ainsi la simulation de l'invention repose sur une compréhension de l'intéraction laser-matériau de chaque impulsion ce qui la rend particulièrement précise et réaliste en comparaison à d'autres méthodes analytiques de l'état de la technique.

La méthode de l'invention permet par la simulation de prédire les paramètres d'usinage laser et permet de les appliquer sur la pièce grâce à un dispositif d'usinage laser, pour obtenir un type d'usinage cible (gravure, découpe, perçage, soudure). Ces caractéristiques/propriétés de chaque matériau (à la fois physiques et fonctions apprises) permettent de prédire les paramètres optimaux (conditions laser) d'usinage à appliquer pour obtenir un usinage voulu.

De préférence,

- le système d'usinage laser est un système apte à émettre un faisceau d'usinage laser en déplacement selon une direction x essentiellement parallèle à une surface d'usinage dudit matériau ;
- l'étape a) comprend de fournir en outre les informations suivantes relatives audit système d'usinage laser :

  ◦ une distance du point de focalisation du faisceau d'usinage laser par rapport à la surface du matériau à usiner,
  ◦ une vitesse (v) de déplacement du faisceau d'usinage laser par rapport audit matériau à usiner
  ◦ un angle d'incidence du faisceau laser d'usinage par rapport à ladite surface du matériau à usiner
  ◦ un nombre de lignes à usiner
  ◦ une distance entre lesdites lignes définie précédemment
  o nombre de passages du faisceau laser d'usinage sur chaque ligne à usiner.

Par exemple, la distance du point de focalisation du faisceau d'usinage laser par rapport à la surface du matériau à usiner est égale à 0 lorsque le point de focalisation est sur la surface. De préférence, la vitesse de déplacement est définie dans la direction x. Par exemple, l'angle d'incidence du faisceau laser d'usinage par rapport à la surface du matériau à usiner est égal à 0° lorsque le faisceau laser décrit un angle de 90° avec la surface du substrat. Par exemple, un nombre de lignes à usiner est de minimum 1 et peut tendre vers l'infini. Préférentiellement, le nombre de lignes à usiner permet de définir une largeur de tranchée en relation avec le paramètre de distance entre les lignes. Préférentiellement, la distance entre lesdites lignes ou pitch est une distance du centre d'une ligne au centre d'une autre ligne adjacente. Par exemple, le nombre de passage du faisceau laser d'usinage sur chaque ligne à usiner est un nombre de couche « layers ». Un nombre de passage du faisceau laser égal à 10 signifie que le faisceau laser passe 10 fois selon une même ligne.

De préférence, le système d'usinage laser est un système apte à émettre un faisceau d'usinage laser en rotation autour d'un axe de rotation essentiellement perpendiculaire à une surface d'usinage dudit matériau et en ce que, l'étape a) comprend de fournir en outre les informations relatives audit système d'usinage laser :

  ◦ une vitesse de rotation $\omega$ dudit faisceau laser autour dudit axe de rotation,
  ◦ une distance BFG par rapport à une surface dudit matériau à usiner pour laquelle le faisceau laser en rotation décrit une tâche fixe pour toutes les positions de faisceau d'usinage laser en rotation,

◦ une distance BFI par rapport à une surface dudit matériau à usiner pour laquelle le faisceau laser en rotation est focalisé,

◦ un angle d'incidence $\beta$ du faisceau laser d'usinage en rotation pour toutes les positions du faisceau laser en rotation par rapport à la normale à la surface du matériau

◦ une durée d'activation du faisceau laser d'usinage en rotation.

De préférence, la vitesse de rotation du faisceau d'usinage laser est la vitesse de rotation d'un élément optique permettant la rotation du faisceau d'usinage laser. Par exemple un tel élément optique est un miroir, un prisme... La une distance BFG par rapport à une surface dudit matériau à usiner pour laquelle le faisceau laser en rotation décrit une tâche fixe pour toutes les positions de faisceau d'usinage laser en rotation, c'est-à-dire un point autour duquel le faisceau d'usinage laser tourne. De préférence, une distance BFI par rapport à une surface dudit matériau à usiner pour laquelle le faisceau laser en rotation est focalisé, par exemple une distance BFI égale à 0 signifie que le faisceau laser est focalisé sur la surface du matériau pour toute les positions du faisceau laser en rotation. De préférence, la distance BFI par rapport à une surface plane d'un matériau à usiner est un plan. De préférence, un angle d'incidence $\beta$ du faisceau laser d'usinage en rotation pour toutes les positions du faisceau laser en rotation par rapport à la normale à la surface du matériau, 0° par rapport à la surface signifie que le faisceau laser en rotation décrit un angle de 90° par rapport à la surface ou de 0° par rapport à la normale de la surface du matériau. De préférence, une durée d'activation du faisceau laser d'usinage en rotation dépend de l'épaisseur et du type de matériau à usiner ainsi que des autres paramètres laser. Ce mode de réalisation est particulièrement aantageux car il permet de simuler avec précision les paramètres laser qui permettront d'avoir des flancs droits ou négatifs (l'orientation des flancs en général).

De préférence, le faisceau laser d'usinage est un faisceau laser d'usinage en rotation autour d'un axe de rotation et d'un point de rotation situé à ladite distance BFG de ladite surface dudit matériau à usiner.

De préférence, que l'étape b) de détermination dudit profil d'usinage en deux et ou trois dimensions comprend une étape de détermination d'un rayon de précession $r_p$ d'un usinage dudit matériau par ledit faisceau laser d'usinage en rotation par la formule suivante :

$$r_P = \left(\frac{BFG}{\cos\beta} - z\right)\tan\beta.$$

De préférence, deux impulsions n successives du faisceau d'usinage en rotation, sont séparées d'une distance $dx$, de préférence le long d'un cercle de rayon $r_p$

De préférence, l'étape b) de détermination dudit profil d'usinage en deux dimensions comprend une étape de détermination d'un rayon de cratère ablaté $r_c$ pour une impulsion du faisceau laser d'usinage par la formule suivante :

$$r_c = w_0 \sqrt{\ln\left(\frac{F_0}{F_{th}}\right)}.$$

De préférence, l'étape b) de détermination dudit profil d'usinage en deux dimensions comprend une étape de calcul d'une profondeur d'ablation $z_n$ par la formule suivante :

$$z_n = -\delta\left[\ln\left(\frac{F_0}{F_{th}(n + NR/2)}\right) - 2\frac{n^2 dx^2}{w^2} - 2\left(\frac{(y + y_c)^2}{w^2}\right)^p\right]$$

De préférence, ledit profil d'usinage est défini en deux dimensions selon :

- un axe y représentant une direction essentiellement parallèle à la surface du matériau à usiner, et,
- un axe z représentant une direction essentiellement perpendiculaire à la surface du matériau à usiner, l'axe z correspondant à une profondeur d'ablation $z_n$ par rapport à la surface du matériau.

De préférence, le delta $\delta$ est un paramètre constant. L'utilisation d'un paramètre constant pour delta $\delta$ est particulièrement avantageux car cela permet d'avoir un paramètre delta $\delta$ constant pour chaque matériau, quelque soit les conditions d'usinage appliquées. Les inventeurs ont trouvé que l'utilisation d'un delta $\delta$ constant était contraire aux enseignements d'un nombre important de publications scientifiques. En particulier, il a souvent été admis que le delta $\delta$ d'un matériau devait varier en fonction d'un nombre d'impulsion d'un faisceau laser, alors que le delta $\delta$ est une propriété intrinsèque du matériau qui ne devrait pas être considéré comme une variable d'ajustement d'un modèle.

De préférence, l'unité centrale est configurée pour éxécuter un programme d'ordinateur pour la détermination dudit profil d'usinage en deux et/ou trois dimensions.

De préférence, la base de données de l'invention permet le stockage d'au moins un type d'information tel que défini ci-après : caractéristiques de matériaux, réponse d'un matériau à une ou plusieurs impulsions laser. Par exemple une base de donnée comprend des caractéristiques de matériaux.

De préférence, lesdites informations relatives audit matériau à usiner sont issues d'une base de données matériaux, dans laquelle chaque matériau comprend les informations suivantes :

○ un delta $\delta$ relatif à une profondeur de pénétration du faisceau laser d'usinage dans le matériau,,

○ une fluence seuil $F_{th}$ relative à une densité d'énergie minimale du faisceau laser permettant un usinage,

○ un coefficient d'incubation S compris entre 0 et 1, relatif à la dépendance de la fluence seuil en fonction d'un nombre d'impulsions du faisceau laser en un même point,

○ un indice de réfraction complexe $n + ik$,

et en ce que ladite unité centrale comprend des moyens de communication pour communiquer avec ladite base de données matériaux.

De préférence la méthode de l'invention permet de réaliser et ou s'applique pour réaliser des simulations permettant d'observer un usinage pouvant être obtenu avec des paramètres définis par un utilisateur. Cela est particulièrement utilisé afin de pouvoir s'assurer de la faisabilité d'un usinage ou encore pour définir des séquences d'usinage.

De préférence, l'unité centrale est configurée pour éxécuter un programme d'ordinateur pour la simulation d'un profil d'usinage laser en deux dimensions.

De préférence la méthode de l'invention prévoit une étape consistant à fournir à l'unité centrale, un programme d'ordinateur permettant d'éxécuter des moyens de modélisation et ou des moyens de simulation. De préférence, les moyens de modélisation/simulation et ou d'apprentissage automatisé comprennent un modèle basé sur des algorithmes permettant de relier des paramètres physiques entre eux. Un programme d'ordinateur est par exemple un logiciel. De préférence, les moyens de modélisation et ou d'apprentissage automatisé sont utilisé pour générer des données pouvant être enregistrées dans la base de données.

De préférence, l'unité centrale configurée pour exécuter ledit programme d'ordinateur est accessible sur des moyens de stockage et de calcul dématérialisés, par exemple un cloud, en particulier une plate-forme en tant que service et plus particulièrement un logiciel en tant que service.

Le logiciel en tant que service, prévoit que ledit programme d'ordinateur est mis à la disposition de l'utilisateur. Le programme d'ordinateur peut être manipulé à l'aide d'un navigateur Web ou installé de façon locative sur une unité centrale. L'utilisateur n'a pas à se soucier d'effectuer des mises à jour, d'ajouter des patches de sécurité et d'assurer la disponibilité du service.

Par exemple, la méthode de l'invetion est une plateforme internet pour aider, un utilisateur souhaitant réaliser un usinage aux moyens d'un dispositif d'usinage laser, à choisir les bons paramètres d'usinages. De préférence la méthode de l'invention est un outil d'aide à la décision. De préférence, les paramètres d'usinage proposés par l'utilisateur à l'unité centrale lors de la simulation sont directement transmis à l'unité de contrôle après vlidation de l'utilisateur.

De préférence, ladite unité centrale comprend des moyens de modélisation et des moyens de simulation de sorte à pouvoir déterminer ledit profil d'usinage en deux dimensions sur la base d'informations relatives audit matériau à usiner issues de ladite base de données, et sur la base d'informations relatives audit système d'usinage laser.

De préférence, la méthode comprend en outre les étapes additionnelles suivantes :

a) fournir un système d'usinage laser comprenant :

- ledit matériau à usiner ;
- ledit dispositif d'usinage laser comprenant :

○ une source laser pour émettre un faisceau d'usinage laser sur ledit matériau à usiner ;
○ une unité de contrôle pour contrôler l'émission dudit faisceau d'usinage laser issu de ladite source laser ;

- ladite unité centrale pour contrôler ladite unité de contrôle ;
- lesdits moyens de comunication pour communiquer avec la base de données ;
- des moyens de communication permettant la communication de ladite unité centrale vers ladite base de données ;

b) usiner ledit matériau avec ladite source laser configurée avec lesdits paramètres d'usinage laser.

De préférence le dispositif d'usinage laser et l'unité d'analyse en particulier comprend des capteurs installés à de nombreux points de la machine pour mesurer la puissance dans la machine et sur cible, un analyseur de profil de faisceau (beam analyser), un analyseur de front d'onde (par exemple avec un Shack-Hartmann), un instrument de mesure du $M^2$, un instrument permettant le calcul de propagation du faisceau avec prédiction de la position et de la taille des waists (position ou la largeur de faisceau est minimale) au long de la propagation du faisceau, des moyens pour corroborer une mesure de la taille du spot et de la position sur la pièce (par exemple avec un Nanoscan). De préférence, la source laser est une source laser ultra-courte, c'est-à-dire pour envoyer des impulsions laser inférieur à 100 ps.

De préférence, le système d'usinage comprend des moyens d'analyse du résultat en temps réel par exemple avec un OCT (Optical Cohérent Tomography), ou après usinage avec interféromètre. Les moyens d'analyse du résultat en temps réel, par exemple des OCT et ou confocal, dont les différentes dimensions mesurées permettent de déduire les caractéristiques physiques des matériaux, et aussi de vérifier le résultat obtenu et d'en déduire une erreur, selon laquelle nous pouvons appliquer une correction d'un ou plusieurs paramètres calculés par l'algorithme utilisé pour la simulation.

La méthode de l'invention présentée dans ce mode de réalisation particulier a aussi pour objectif de fournir et d'alimenter une base de données matériau qui permet ensuite la prédiction par simulation des paramètres lasers optimaux propres à chaque matériau, selon des critères ou dans des intervalles d'erreur de résultat souhaité. L'invention inclut un système laser d'usinage pouvant être équipé de différentes sources laser (laser system apparatus), système de management du faisceau laser (beam management), unité d'usinage permettant le déplacement relatif du faisceau laser par rapport à la pièce à usiner (machining unit) et une unité d'analyse permettant d'obtenir un résultat par rapport à un usinage effectué (analysis unit). Un avantage de l'invention est de disposer d'une base de données matériaux permettant le stockage de caractéristiques de matériaux. Cette base de données matériaux permet de disposer de caractéristiques de matériaux dès le démarrage d'un nouvel usinage afin de bénéficier des résultats d'expériences passées lorsque ceux-ci sont compatible avec l'expérience en cours, en particulier lorsque le matériau à usiner est connu de la base de données.

De préférence, ledit dispositif d'usinage laser comprend en outre :

 o une unité d'analyse de l'état dudit matériau à usiner connectée à ladite unité centrale pour fournir un résultat d'usinage,

et en ce que les étapes additionnelles suivantes sont mises en oeuvre :

 c) acquérir avec ladite unité d'analyse après l'étape d), des résultats d'usinage ;
 d) transmettre lesdits résultats d'usinage et lesdits paramètres d'usinage à ladite unité centrale, ladite unité centrale étant configurée pour déterminer des informations relatives au matériau à usiner ;
 e) enrichir ladite base de données matériaux avec lesdites informations relatives au matériau à usiner issues de l'unité centrale.

Ce mode de réalisation préféré de l'invention, permet un enrichissement de la base de données matériaux selon l'invention pour lequel un algorithme d'optimisation/une optimisation telle que décrite peut être appliqué par l'unité centrale de sorte à réduire les erreurs dues à la mesure ou à d'autres facteurs extérieurs.

### Données utilisées par l'unité centrale

Les données utilisées par l'unité centrale comprennent au moins un type de données ayant la caractéristique suivante : donnée décrivant un résultat cible ou à atteindre, des paramètres utilisateurs, des caractéristiques liées à la machine, des instructions correspondant à des tests prédéfinis, des paramètres liés à un matériau à usiner, des paramètres liés à un matériau stockés dans une base de données, des paramètres liés à un matériau stockés dans une base de données et obtenus lors d'un usinage précédent, des algorithmes comprenant des fonctions d'apprentissage, des paramètres d'usinage optimaux, des données issues des moyens de mesure du faisceau laser, des données issues des moyens d'analyse du résultat. De préférence les types de données décrites ci-avant sont annotées.

### Nettoyage des données

Une étape de nettoyage des données collectées ou présentes dans la base de données est prévu selon un mode de réalisation préféré de l'invention. Cette étape permet de s'assurer que les données collectées à partir d'une base de données ou mesurées en ligne sont consistantes, sans valeurs aberrantes ni valeurs manquantes.

**Résultats cible et prédéfinis**

La tâche spécifique à accomplir ou résultat à atteindre ou résultat d'usinage cible ou résultat cible prédéfini selon l'invention correspond au problème qu'un utilisateur de la présente invention cherche à résoudre grâce à la modélisation/simulation du phénomène. L'invention permet de considérer une pluralité de résultats d'usinage cibles, chacun des résultats d'usinage cibles pouvant nécessiter le choix d'algorithmes de simulation différents.

De préférence l'unité centrale du système d'usinage laser regroupe le contrôle de toutes les unités comprises dans celui-ci et en particulier d'au moins : la source laser, du dispositif de management du faisceau, de l'unité de déplacement du faisceau/focalisation, de l'unité d'analyse, d'une base de données, d'une base de données matériaux, d'une unité d'observation, d'une unité, d'une unité pour mettre en oeuvre la modélisation/simulation, d'une unité comprenant des caractéristiques de tests prédéfinis. Une unité centrale est par exemple un ordinateur comprenant plusieurs interfaces d'entrées et de sorties. L'unité centrale est de préférence connectée à un réseau, par exemple à Internet permettant par exemple une délocalisation des unités permettant de mettre en oeuvre la modélisation/simulation. L'avantage que les unités permettant de mettre en oeuvre la modélisation/simulation ne soient pas physiquement présente dans le système d'usinage laser permet de disposer d'une unité centrale ne nécessitant pas les ressources matérielles, par exemple puissance de calcul nécessaire à la mise en oeuvre de la modélisation/simulation. Cela permet également d'avoir un système d'usinage laser avec une unité centrale dédiée à l'usinage laser. De préférence la ou les bases de données sont également stockés sur un serveur central, de préférence le serveur centrale étant situé au même endroit que les unités pour mettre en oeuvre la modélisation/simulation.

De préférence, ladite base de données comprend des informations relatives audit matériau d'au moins l'un des types suivants : fonction apprise, caractéristiques physique d'un matériau.

De préférence, lesdites caractéristiques physiques d'un matériau comprennent au moins l'une des caractéristiques suivantes : un delta, une fluence seuil, une fluence d'efficacité maximale.

De préférence, ladite unité d'analyse de l'état dudit matériau à usiner est une unité de détection optique.

De préférence les paramètres d'usinage laser comprennent au moins l'un des paramètres suivants :

- une vitesse de balayage du faisceau laser sur le matériau à usiner ;
- un nombre d'impulsions par seconde émis par ladite source laser ;
- une longueur d'onde émise par la source laser ;
- une taille de spot de la source laser sur le matériau à usiner ;
- une énergie par impulsion émise par ladite source laser ;
- angle d'incidence du faisceau sur la pièce ;
- un nombre de passages ou de couches à usiner ;
- la distance séparant deux lignes adjacentes conjointes ;
- nombre de tours par minute du système de rotation optique.

De préférence, l'unité de contrôle est en outre configurée pour contrôler ledit faisceau lumineux issu de ladite source laser vers ledit matériau à usiner.

De préférence, la méthode comprend en outre l'étape additionnelle suivante :

f) acquérir une information relative audit matériau à usiner permettant une identification dudit matériau à usiner par l'unité centrale.

De préférence, la méthode comprend en outre l'étape additionnelle suivante :

g) déterminer en outre une stratégie d'usinage sur la base dudit usinage dudit matériau à usiner.

De préférence, la méthode comprend en outre les étapes additionnelles suivantes :

h) irradier ledit matériau à usiner avec ledit faisceau lumineux avec des paramètres de faisceau lumineux prédéterminés ;

i) acquérir par l'unité de détection optique un résultat engendré par l'irradiation dudit matériau à usiner par ledit faisceau lumineux ;

j) transmettre ledit résultat à l'unité centrale et accéder audit résultat engendré par l'irradiation dudit matériau à usiner par ledit faisceau lumineux ;

k) extraire dudit résultat aux moyens de l'unité centrale, au moins un paramètre d'usinage laser relatif à un matériau ;

l) enregistrer ledit au moins un paramètre d'usinage laser relatif à un matériau dans ladite base de données.

Un système d'usinage laser selon un deuxième aspect de la présente invention est défini dans la revendication 13.

Les différentes variantes et avantages décrits pour la méthode selon le premier aspect de l'invention s'appliquent au système du second aspect, mutadis mutandis.

De préférence, le système comprend en outre une unité optique pour diriger ledit faisceau laser vers ledit matériau à usiner.

De préférence, ladite unité optique pour diriger ledit faisceau laser vers ledit matériau à usiner permet la précession dudit faisceau laser.

Selon un troisième aspect de la présente invention, un programme d'ordinateur comprenant des instructions qui, lorsque le programme est exécuté par un ordinateur, conduisent celui-ci à mettre en oeuvre la méthode selon le premier aspect de la présente invention est défini dans la revendication 14.

Les différentes variantes et avantages décrits pour la méthode selon le premier aspect de l'invention et pour le système selon le second aspect de l'invention s'appliquent au programme d'ordinateur du troisième aspect, mutadis mutandis.

De préférence, le programme d'ordinateur comprenant les instructions qui conduisent le système d'usinage laser selon le deuxième aspect de l'invention à executer les étapes de la méthode selon le premier aspect de l'invention.

Selon un quatrième aspect de la présente invention, un support de données lisible par ordinateur, sur lequel est enregistré le programme d'ordinateur selon le troisième aspect de l'invention est défini dans la revendication 15.

Les différentes variantes et avantages décrits pour la méthode selon le premier aspect de l'invention, pour le système selon le second aspect de l'invention et pour le programme d'ordinateur selon le troisième aspect de l'invention s'appliquent au support lisible par ordinateur du quatrième aspect, mutadis mutandis.

**Détermination des paramètres d'usinage laser sur la base des paramètres d'usinage laser relatif au matériau d'une pièce à usiner**

Lorsqu'il est décidé de procéder à l'usinage d'une pièce, un usinage cible de cette pièce est défini. De préférence un usinage cible d'une pièce est un trou, une rainure, une gorge, une découpe ou tout autre usinage obtenu par ablation, traversant ou non traversant que l'opérateur souhaite réaliser dans une pièce. De préférence, un usinage cible est défini dans un espace bidimensionnel, et de façon plus préférée dans un espace tridimensionnel. Par exemple un usinage cible défini une un volume de matériau à ablater. Un usinage cible peut par exemple correspondre à une découpe ou encore à la modification des propriété optique d'un matériau transparent.

Afin de réaliser l'usinage cible avec les tolérances d'usinage les plus réduites possible, il convient de déterminer les paramètres d'usinage en fonction de la nature de la pièce à usiner, c'est-à-dire sa composition, sa forme initiale ainsi que des propriétés de la source laser utilisée. La méthode de l'invention permet la détermination des paramètres d'usinage laser sans nécessairement recourir à des tests empiriques au préalable. En effet grâce à l'utilisation des différents modèles qui seront détaillés plus loin et en connaissant les paramètres d'interaction du matériau de la pièce à usiner lorsqu'elle est irradiée par le faisceau lumineux, il est possible de déterminer les paramètres d'usinage laser. Les paramètres d'usinage laser déterminés lorsqu'ils sont mis en oeuvre selon la méthode de l'invention permettent d'obtenir l'usinage qui serait obtenu lors d'un usinage avec un système d'usinage laser.

Les paramètres d'usinage laser sont de préférence définis pour un dispositif d'usinage laser et comprennent de façon non-exhaustive :

- une vitesse de balayage du faisceau laser sur la pièce à usiner ;
- un nombre d'impulsions par seconde émis par ladite source laser ;
- une longueur d'onde émise par la source laser ;
- une taille de spot de la source laser sur le matériau à usiner ;
- une quantité d'énergie par impulsion émise par ladite source laser ;
- une durée d'impulsion émise par ladite source laser.

Une pièce à usiner étant définie par un matériau la composant ainsi que par des dimensions. Les dimensions peuvent par exemple être définies dans un espace multidimensionnel afin de bien définir les emplacements de matière et les emplacements ou aucune matière n'est présente. Une dimension peut par exemple définir une rugosité de la pièce à usiner, par exemple une rugosité peut être définie pour chacune des faces de la pièce à usiner lorsque celle-ci est définie par des faces.

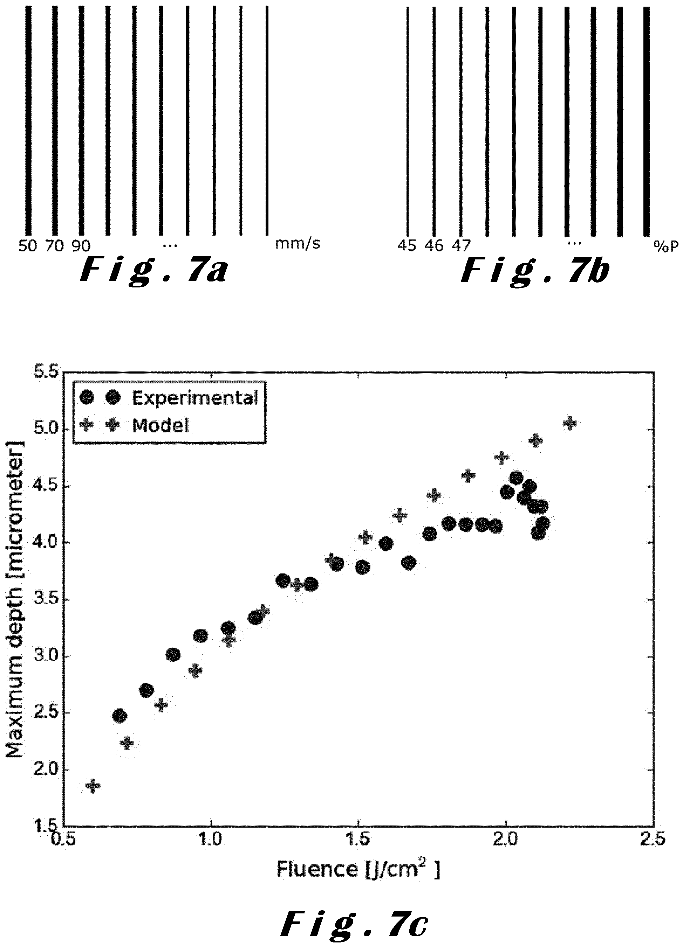

Il est possible de déterminer le $\delta$ à partir des équations décrites ci-après, cependant il n'est pas toujours facile d'avoir tous les paramètres, constants ou coefficients nécessaires pour faire ce calcul. Grâce à la méthode de l'invention il est possible de déterminer un $\delta$ expérimentalement tout en prenant en compte la variabilité de certains paramètres. Pour cela, il faut produire des balayages sur la surface du matériau, avec des valeurs de puissance constantes et des valeurs de vitesse croissantes, et avec des valeurs de vitesse constantes et des valeurs de puissance croissantes, comme illustré de façon exemplative dans en Figure 7a et 7b. De préférence, les profondeurs maximales doivent être mesurées et comparées avec les valeurs obtenues avec le modèle correspondant décrit ci-après. La valeur $\delta$ utilisée dans le modèle doit être ajustée jusqu'à obtenir une bonne coïncidence entre les points expérimentaux et les points modelés.

Plus généralement, le coefficient δ, décrit comme le coefficient d'absorption et utilisé mathématiquement comme facteur d'étalonnage. Il est connu de l'état de la technique que le coefficient δ varie avec le nombre d'impulsions accumulées en raison d'un coefficient d'incubation S, ainsi de la même manière que pour le seuil d'ablation, le coefficient δ est : $\delta(N) = \delta(1) N^{(S-1)}$.

Dans la simulation numérique de l'invention, le coefficient δ est considéré comme constant tout au long du calcul numérique du profil d'ablation, ce qui donne des résultats assez similaires à ceux obtenus expérimentalement avec les mêmes paramètres de traitement.

## Détermination du seuil d'ablation par la méthode du $D^2$.

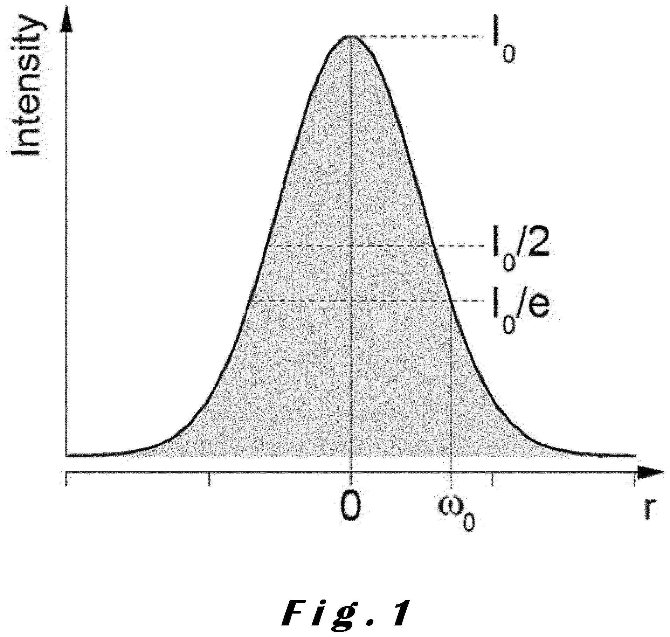

La détermination du seuil d'ablation par la méthode du $D^2$ est la plus acceptée et la plus utilisée pour déterminer le seuil d'ablation de tous les types de matériaux. Cette méthode est utilisée pour des profils d'énergie de faisceau Gaussien (voir Figure 1). Cette méthode présente l'avantage d'offrir la possibilité d'estimer le rayon du faisceau Gaussien ω à la surface du matériau et le coefficient d'incubation.

La fluence (ou densité d'énergie) dans un plan perpendiculaire à l'axe du faisceau laser est donnée par :

$$F(r) = F_0 \exp\left(\frac{-2r^2}{\omega^2}\right), \qquad (1)$$

où r est la distance à l'axe du faisceau, $\omega^2$ le rayon du faisceau à la surface du matériau à $e^{-2}$ de l'intensité maximale. Si le faisceau est focalisé à la surface, $\omega = \omega_0$. $F_0$ est la fluence maximale (à r = 0) et se calcule et est donnée par :

$$F_0 = \frac{2E_P}{\pi\omega^2}. \qquad (2).$$

Le diamètre d'un cratère d'ablation produit avec une ou plusieurs impulsions laser peut être décrit en fonction de la fluence maximale :

$$D^2 = 2\omega^2 \ln\left(\frac{F_0}{F_{th}}\right), \qquad (3)$$

où $F_{th}$ est le seuil d'ablation. Comme $F_0$ augmente linéairement avec $E_P$, le rayon du faisceau ω peut être estimé à partir du graphique des diamètres des cratères $D^2$ en fonction du logarithme de l'énergie d'impulsion, en utilisant l'équation 3. Le rayon ω peut être calculé à partir de la pente d'une courbe définie par les résultats expérimentaux :

$$\omega = \sqrt{\frac{pente}{2}}. \qquad (4)$$

Le seuil d'ablation peut être calculé en extrapolant le diamètre des cratères à la puissance 2 à un diamètre de cratère égal à zéro dans un graphique représentant le diamètre des cratères à la puissance 2 ($D^2$) en fonction du logarithme de l'énergie d'impulsion.

En général, le seuil d'ablation diminue en augmentant le nombre d'impulsions incidentes pour un même point de la surface du matériau à usiner. Ce comportement est attribué à l'augmentation de l'absorptivité de radiation causé par l'accumulation des défauts créé à chaque impulsion, même à des fluences plus basses que la fluence seuil. Une telle augmentation de l'absorptivité de radiation peut être caractérisée par un facteur ou coefficient d'incubation, exprimé par les équations suivantes (5) et (6) :

$$F_{th}(N) = F_{th}(1) \times N^{S-1} \quad (5)$$

Lorsque $F_{th}(N)$ est la fluence du seuil d'ablation pour N impulsions, Fth(1) est la fluence du seuil d'ablation pour une impulsion unique et S est le coefficient d'incubation. S = 1 signifie qu'il n'y a pas d'incubation, c'est-à-dire que le seuil d'ablation est indépendant du nombre d'impulsions. Pour la plupart des matériaux S <1, le seuil d'ablation diminue avec l'augmentation du nombre d'impulsions.

De façon générale, l'incubation ou la diminution de la fluence seuil, est plus accentuée pendant premières cent impulsions pour une grande majorité des matériaux et en particulier pour les matériaux utilisés les plus couramment.

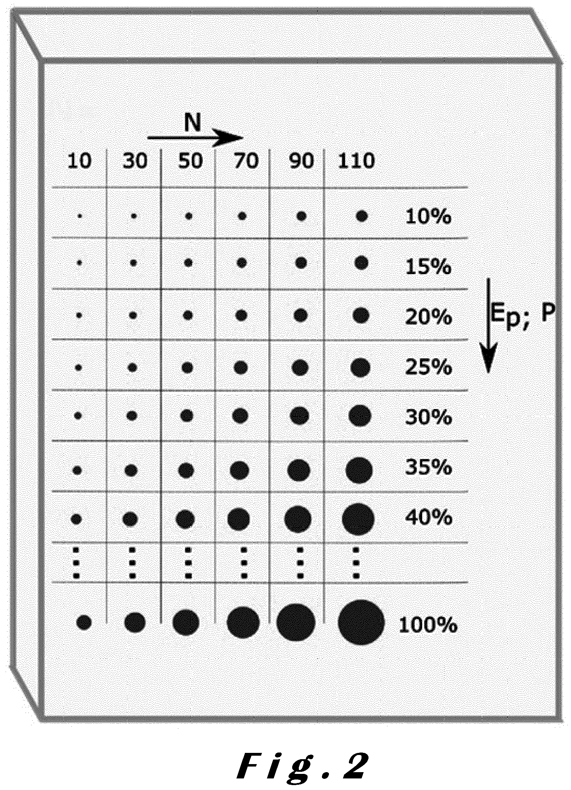

Pour appliquer la méthode D$^2$ pour trouver le seuil d'ablation, le coefficient d'incubation et, si besoin, le rayon du faisceau, il faut produire une matrice de cratères avec des nombres d'impulsions et des énergies d'impulsion croissants, comme illustré en Figure 2. Pour avoir des points expérimentaux suffisants, il faut avoir au moins 20 valeurs d'énergie, et plusieurs valeurs de nombre d'impulsions inférieur à 100 impulsions. Le diamètre de chaque cratère doive être mesure à partir des images obtenues avec un microscope optique ou électronique.

**Détermination du seuil d'ablation par la méthode Diagonal Scan.**

La méthode Diagonal-Scan ou D-Scan est une méthode géométrique pour déterminer la valeur du seuil d'ablation. La méthode D-Scan est une méthode alternative à la méthode D$^2$, elle a l'avantage d'être plus efficace et plus rapide en terme de temps d'expériences et de nombres de mesures à réaliser. Le désavantage de cette méthode par rapport au D$^2$ est lié à la méthode permettant de déterminer le rayon du faisceau, une valeur toujours importante pour les mesures et calcul des paramètres.

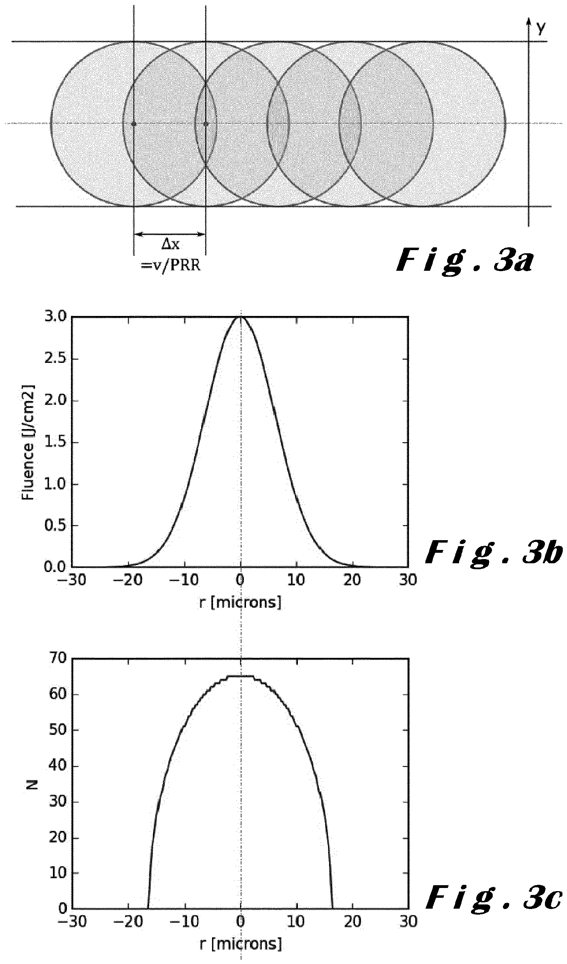

La méthode Diagonal-Scan consiste à déplacer l'échantillon diagonalement par rapport au point focal du faisceau en utilisant différentes énergies de faisceau et un nombre d'impulsions variables, tout en changeant la vitesse de déplacement (Figure 3). Les expériences permettant de mettre en oeuvre la méthode D-Scan prévoient la détermination de la surface ablatée. La surface ablatée correspond aux points pour lesquels la puissance de la radiation a excédée une valeur critique définie par :

$$P_{crit} = \frac{1}{2} e\pi\omega_0^2 I_{th}, \quad (7)$$

où $I_{th}$ est le seuil d'ablation en terme d'intensité, donné par :

$$I_{th} = \frac{P_0}{e\pi\rho_{max}^2}, \quad (8)$$

où $P_0$ est la puissance maximale d'impulsion et $\rho_{max}$ est la largeur maximale de la région ablatée (Figure 3). Le seuil d'ablation est donné par :

$$F_{th} = I_{th}\tau_p, \quad (10)$$

Où $\tau_p$ est la durée d'impulsion.

Pour appliquer la méthode D-Scan pour trouver le seuil d'ablation et le coefficient d'incubation il faut produire des scans comme illustré dans la Figure 3, avec différentes valeurs d'énergie et vitesse de déplacement afin d'avoir mesures pour différents nombres d'impulsions superposés. Le nombre d'impulsions superposés aux points correspondants à la partie plus large des lobes est donné par :

$$N = \sqrt{\pi} \frac{f \times \rho_{max}}{v_y}, \quad (11)$$

où $f$ est la fréquence d'impulsion et $v_y$ la vitesse dans la direction de l'axe y.

**Détermination du $\delta$ par la méthode *"Skin depth"***

Pendant l'interaction entre une impulsion laser ultracourte et un solide, les électrons n'ont pas le temps de transférer leurs énergies aux ions, car le temps de couplage électron-phonon est plus long que la durée d'impulsion. Dans ces conditions, on peut considérer que la densité électronique reste constante et le champ électromagnétique dans le solide peut se calculer avec les équations de Maxwell en combinaison avec les équations du matériau. On peut considérer aussi que dans ce cas-là le champ électrique du laser à la surface du matériau diminue exponentiellement avec la profondeur par rapport à la surface du matériau :

$$E(x) = E(0)\,exp\left(-\frac{x}{\delta}\right), \qquad (12)$$

où $\delta$ est la profondeur de pénétration ou absorption du champ (« *skin depth* »). La surface du matériau correspond à $x = 0$ et l'équation (12) est valide pour $x > 0$. En général, la profondeur d'absorption s'exprime comme :

$$\delta = \frac{c}{\omega_L \kappa}, \qquad (13)$$

où $\kappa$ est la partie imaginaire de l'indice de réfraction,

$$N = \sqrt{\varepsilon} = n + i\kappa, \qquad (15)$$

où $\varepsilon = \varepsilon' + i\varepsilon''$ est la fonction diélectrique est $\omega_L$ est la fréquence du laser. On peut considérer la fonction diélectrique dans la formule de Drude pour les calculs suivants :

$$\varepsilon = 1 - \frac{\omega_{pe}^2}{\omega(\omega + iv_{eff})}, \qquad (16)$$

où

$$\omega_{pe} = \sqrt{\frac{4\pi e^2 n_e}{m_e}} \qquad (17)$$

$\omega_{pe}$ est la fréquence du plasma d'électrons, $v_{eff}$ est la fréquence de collision effective entre les électrons et le réseau (ions), et $m_e$ et $n_e$ sont la masse et densité des électrons de conduction, respectivement. Dans le cas d'un taux de collision élevé, $v_{eff} \gg \omega$ et donc $\varepsilon'' \gg \varepsilon'$, l'équation (13) peut se réduire à la forme suivante :

$$\delta = \frac{c}{\omega_L \kappa} \approx \frac{c}{\omega_{pe}} \sqrt{\frac{2v_{eff}}{\omega_L}}. \qquad (18)$$

**Détermination du $\delta$ par la profondeur d'ablation.**

Dans les conditions de non-équilibre concernant la détermination du $\delta$ par la méthode "Skin depth", le temps de conduction thermique des électrons $(t_{heat})$, ou le temps pour que les électrons atteignent l'équilibre thermique dans la région dans la couche de peau est aussi plus long que la durée d'impulsion du laser. Le temps $t_{heat}$ est donné peut être approximé par l'équation suivante, avec une expression du coefficient de diffusion thermique suivante :

$$t_{heat} \approx \frac{\delta^2}{\kappa_T}; \quad \kappa = \frac{l_e v_e}{3}, \quad (19)$$

où $\kappa_T$ est le coefficient de diffusion thermique, et $l_e$ et $v_e$ sont le libre parcours moyen des électrons et sa vitesse, respectivement.

Les lois de conservation d'énergie ont dans ce cas une forme qui décrit la variation de la température des électrons causée par l'absorption d'énergie dans une couche de peau :

$$c_e(T_e) n_e \frac{\partial T_e}{\partial t} = -\frac{\partial Q}{\partial x}, \quad (20)$$

où Q est le flux d'énergie absorbé dans la couche de peau :

$$Q = A I_0 \exp\left(-\frac{2x}{\delta}\right), \quad (21)$$

où $A = I/I_0$ est le coefficient d'absorption, $I_0 = cE^2/4\pi$ est l'intensité incidente du laser. Le coefficient d'absorption et la profondeur de peau sont donc fonction de la fréquence du laser $\omega_L$, de la densité des électrons de conduction $n_e$, de la fréquence effective de collision électron - électron et électron - ion $v_{eff}$, de l'angle d'incidence et de la polarisation du laser.

La profondeur d'un cratère $z$ produit avec un laser ultra-rapide ayant une fluence F est de l'ordre de la profondeur de pénétration du faisceau, selon les équations :

$$z = \delta \ln \frac{F}{F_{th}}, \quad (22)$$

où $F_{th}$ est une fluence seuil pour l'ablation et $\delta$ est une longueur ayant plusieurs interprétations dépendant des approximations dans les équations à deux températures et la gamme de fluence. Typiquement, dans le domaine de faible fluence, $\delta$ est lié au coefficient d'absorption optique et, pour des fluences plus élevées, à des paramètres thermiques tels que la diffusion électronique et la durée d'interaction temporelle. Pour de nombreux matériaux, il existe différentes valeurs de $F_{th}$ et $\delta$ aux fluences haute et basse, la frontière dépendant des matériaux. Chaque matériau est alors représenté par un ensemble de paramètres ($\delta$, $F_{th}$) dans une zone de fluence donnée. La fluence laser F pour un faisceau laser de profil d'intensité gaussien est donnée par:

$$F(r) = F_0 \exp\left(-\frac{2r^2}{\omega_0^2}\right) \quad (23)$$

où r est la distance radiale (distance avec le centre du faisceau laser), $F_0$ est le pic de fluence ou de fluence au centre du faisceau et $\omega_0$ est le rayon du faisceau à $1/e^2$ de l'intensité maximale. La fluence maximale $F_0$ peut être obtenue à partir de l'énergie d'impulsion $E_p$:

$$F_0 = \frac{2E_p}{\pi \omega_0^2}. \quad (24)$$

La profondeur d'ablation par pulse après irradiation par un faisceau gaussien est donné par la relation :

$$z_G(r) = \delta \ln\left(\frac{F_0}{F_{th}}\right) - 2\frac{r^2}{\omega_0^2}. \qquad (25)$$

Ce modèle est basé uniquement sur la réponse de la matière à la fluence appliquée. Tous les effets géométriques décrits par cette approche seront liés à la répartition temporelle ou spatiale de la fluence.

Dans le cas d'une irradiation multi-impulsionnelle, il est tenu compte du fait que la topographie de surface n'est plus plane mais devient paraboloïde, sa profondeur augmentant après chaque impulsion laser consécutive. Par conséquent, quelques considérations sont essentielles pour parvenir à une meilleure prédiction des dimensions de l'ablation. La première condition qui ne doit pas être négligée est l'incubation, ou la diminution du seuil d'ablation avec le nombre d'impulsions. Deuxièmement, il faut tenir compte des effets de l'angle de surface local sur l'absorption d'énergie et la réflectivité.

Enfin, et étant donné que l'irradiation multi-impulsionnelle est typiquement utilisée pour obtenir des cratères plus profonds ou des balayages laser, la variation du faisceau gaussien de la fluence avec la profondeur doit également être considérée.

Cette description est valide pour des fluences relativement faibles par rapport au seuil d'ablation. Pour des fluences plus élevés, il faut également considérer des paramètres thermiques comme la diffusion électronique ou la durée de l'interaction laser-matière.

## Ablation selon une ligne

Dans la plupart des applications, une description statique n'est pas pertinente si l'échantillon ou le faisceau est en mouvement. Une description numérique peut être utilisée pour des situations dynamiques. Considérons un mouvement dans la direction x avec une vitesse v. Le taux de répétition des impulsions du laser étant PRR, la distance $\Delta x$ entre deux impulsions successives est:

$$\Delta x = \frac{v}{PRR}. \qquad (26)$$

Dans ce cas, il n'est pas possible de supposer une symétrie radiale et la fluence est alors une fonction de la position en x et en y. Il est alors nécessaire d'introduire un nombre d'impulsions N vu par le matériau pour un passage. La profondeur d'ablation pouvant alors être exprimée selon l'équation suivante :

$$z_k(0, y) = \delta \ln\left(\frac{F_0}{F_{th(N)}}\right) - 2\frac{k^2\Delta x^2}{\omega_0^2} - 2\frac{y^2}{\omega_0^2} \qquad (27)$$

ou,

$$Z(y) = \frac{\Delta x \delta \sqrt{2}}{3\omega_0} \sqrt{\ln\left(\frac{F_0}{F_{th}}\right) - 2\frac{y^2}{w_0^2}} \left\{ 2\frac{\omega_0^2}{\Delta x^2}\left[\ln\left(\frac{F_0}{F_{th}}\right) - 2\frac{y^2}{w_0^2}\right] - 1 \right\} \qquad (27'),$$

où $\Delta x$ la distance entre deux impulsions consécutives, F0 est la fluence de crête, Fth est la fluence du seuil d'ablation et w0 est le rayon du point. X est donné par v / PRR, où v est la vitesse de balayage et PRR est le taux de répétition des impulsions.

Dans les cas où la position de focalisation du faisceau n'est pas corrigée avec l'augmentation de la profondeur du cratère ou de la ligne, ce qui est généralement le cas, dans l'équation précédente, $\omega_0$ doit être remplacée par $\omega(z)$. Le profil du cratère devient un profil "ligne" Z (y) défini par:

$$Z(y) = \sum_{k=-N}^{N} z_k(y). \qquad (28)$$

Pour effectuer le calcul analytique de l'équation précédente, il faut noter que le nombre d'impulsions dépend de y, c'est-à-dire qu'il n'est pas le même le long du profil de ligne entier. Un nombre d'impulsion peut être déterminé selon la direction perpendiculaire à ladite ligne par l'équation suivante :

$$N(y) = \frac{\omega_0}{\sqrt{2}\Delta x}\sqrt{\ln\left(\frac{F_0}{F_{th(N)}}\right) - 2\frac{y^2}{\omega_0^2}} . \quad (29)$$

Il apparait important de noter que le nombre total d'impulsions vues par un point de l'échantillon pour un passage est 2N + 1. Cette expression conduit à plusieurs commentaires. Tout d'abord, le profil de ligne n'est plus parabolique comme c'était le cas pour un pluralité d'impulsions statiques. Ensuite, en fonction de la valeur de $\Delta$, le nombre maximum d'impulsions peut être faible, par exemple inférieur à 10. Dans la plupart des matériaux, les effets d'incubation doivent également être pris en compte pour obtenir des résultats réalistes avec les trois équations précédentes.

Lors de l'ablation de matériau selon une ligne, la fluence (F) exprimée en J/cm2 peut être exprimée selon la direction perpendiculaire à ladite ligne par l'équation suivante :

$$F(y) = F_0 \exp\left(-\frac{2k^2\Delta x^2}{\omega_0^2}\right)\exp\left(-\frac{2y^2}{\omega_0^2}\right), \quad (30)$$

$\Delta x$ décrivant la distance entre les centres de deux impulsions successives, $F_0$ étant la fluence crête du faisceau laser, k ..., $\omega_0$ étant une largeur de faisceau minimale,

Le seuil d'ablation $F_{th}$ étant un paramètre relatif à une fluence en $J.cm^{-2}$, les hypothèses suivantes concernant une valeur de seuil d'ablation sont de préférence :

- la redéposition de débris est négligeable ;
- la vitesse d'ablation n'est pas affectée par l'interaction avec les pulses précédents ;
- il n'y a pas d'accumulation de chaleur ou d'effet thermique à la surface du matériau ni d'absorption plasma ;
- il n'y a pas de réflexion interne.

En ce qui concerne les performances d'une machine d'usinage laser, un taux d'ablation par un faisceau laser peut être défini par l'équation suivante :

$$\frac{dV}{dt} = \frac{f\delta\pi}{6}\ln(\frac{F_0}{F_{th}})\left[\ln(\frac{F_0}{F_{th}}) - \Delta x^2\right]. \quad (31)$$

Un taux d'ablation par fluence pouvant également être défini par l'équation suivante :

$$\frac{dV}{dt}/F_0 = \frac{fS\Delta x}{F_0}. \quad (32)$$

Un taux d'ablation maximal pouvant alors être défini par l'équation suivante :

$$(\frac{dV}{dt}/F_0)_{max} = \frac{2}{e^2}\frac{\delta}{F_{th}}. \quad (33)$$

Les équations définissant le taux d'ablation présentent des limites car elle ne permettent pas de prendre en compte les paramètres suivants :

- saturation due à la conicité de la partie usinée ;
- réflectivité (S,P) ;
- incubation ;

- effets thermiques.

Il est possible de prendre en compte les paramètres précités dans un modèle permettant la prédiction des paramètres d'usinage pour un usinage cible. En simulant les profils d'ablation pour toutes les plages de fluence du faisceau laser avec les équations définissant ces profils d'ablation et en faisant varier les paramètres non pris en compte dans ces équations. Une telle méthode serait beaucoup trop lente et nécessiterait une trop grande quantité d'expériences.

Réaliser un plan d'expérience avec un nombre de paramètres limités et identifier les paramètres ayant la plus grande influence sur les résultats finaux.

Détermination de la fluence seuil en utilisant un modèle de balayage diagonal (Diagonal-Scan)

$$\phi_{th} = \frac{E_p}{e\pi\rho_{max}^2}. \qquad (34)$$

**Prise en compte de l'angle d'incidence local du faisceau**

Une façon d'introduire cette correction d'angle de surface local est de considérer que la fluence varie avec la distance au centre de cratère r, puisque l'angle entre la direction du faisceau et la surface varie du bord du cratère à son centre. Pour un cratère profond cet angle est faible sur les murs mais devrait atteindre 90 ° au centre. La conicité γ(r) des murs est directement liée à la dérivée du profil du cratère au r considéré:

$$\tan\big(\gamma(r)\big) = \frac{dz}{dr} z_k(r), \qquad (35)$$

qui est égale à la pente de la tangente à chaque point du profil du cratère (indiqué dans la figure ci-dessous par la ligne rouge L). La fluence locale après N impulsions, F_N (r), peut donc être simplement exprimée comme suit :

$$F_N(r) = F(r)\cos(\gamma(r)). \qquad (36)$$

Il peut être noté que l'équation précédente peut également être utilisée même si la fluence reste constante d'une impulsion à l'autre, par exemple si l'échantillon est déjà percé ou pour une forme de cratère large.

**Prise en compte d'une incidence de faisceau non-normale**

Il existe plusieurs applications qui nécessitent des parois de cavité perpendiculaires à la surface, ce qui est difficile à obtenir si le faisceau laser est balayé normalement vers la surface. Des conicités de paroi négatives ou à 0 ° peuvent cependant être obtenues si le faisceau laser est incliné par rapport à la surface. Pour modéliser ceci, il faut aussi considérer l'angle de surface par rapport au faisceau. L'équation précédente devient ainsi :

$$F_{abs,N}(r) = F_N(r)(1 - R)\cos(\gamma(r) + \beta) \qquad (37)$$

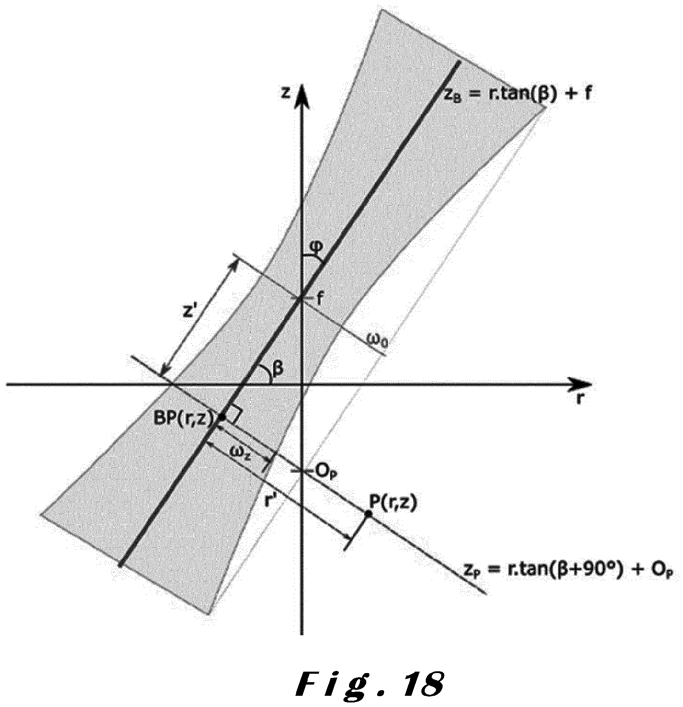

où β est l'angle entre la normale à la surface et le faisceau laser (Figure 1). Il faut également considérer que la direction d'ablation doit être parallèle à la direction du faisceau plutôt que perpendiculaire à la surface d'origine. Les coordonnées référentielles doivent donc être adaptées en conséquence, comme illustré sur la figure 18b.

Comme indiqué précédemment, la fonction (27) ou (27')peut être valable pour l'ablation de rainure avec le faisceau perpendiculaire à la surface, mais elle ne le sera plus dans les cas où le faisceau est incliné par rapport à la normale à la surface en utilisant des paramètres de traitement conduisant à des conicités négatives. Dans de tels cas, il y aura une position y correspondant à plus d'une profondeur z. La conicité minimale pouvant être obtenue avec cette approche tend donc vers 0 °.

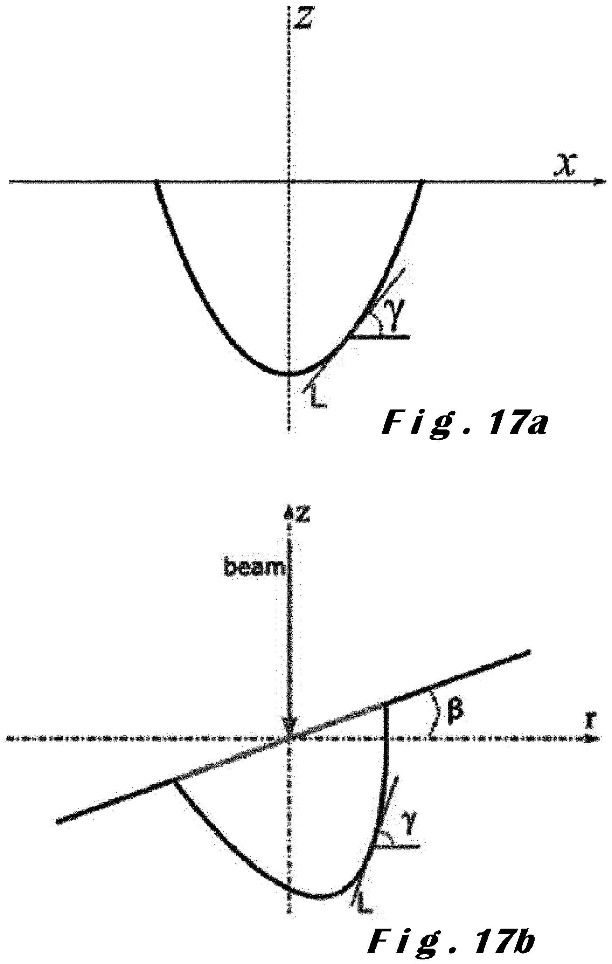

Pour surmonter cette limitation, le modèle effectue numériquement ce type de calcul en inclinant la surface avant le calcul de la profondeur (Fig. 17b) plutôt qu'en inclinant le faisceau. L'avantage d'une telle méthode est de permettre la simulation d'usinages ayant une conicité négative.

**Prise en compte de la réflectivité**

La polarisation joue un rôle majeur dans les processus d'ablation laser des métaux en raison du rôle des faisceaux réfléchis. L'évolution de la réflectivité avec l'angle d'incidence $\alpha$ est donnée par les formules de Fresnel pour les polarisations s, p circulaires:

$$R_s = \left| \frac{\sqrt{n^2 - \sin^2 \alpha} - \cos \alpha}{1 - n^2} \right|^2 \qquad (38)$$

$$R_p = \left| \frac{n^2 \cos \alpha - \sqrt{n^2 - \sin^2 \alpha}}{n^2 \cos \alpha + \sqrt{n^2 - \sin^2 \alpha}} \right|^2 \qquad (39)$$

$$R_{circular} = \frac{R_s + R_p}{2} \qquad (40)$$

La fluence absorbée par le matériau est alors donnée par l'expression suivante :

$$F_{abs}(r) = F(r)(1 - R) \qquad (41)$$

où R est $R_S$, $R_P$ ou $R_{circular}$ selon la direction de rayonnement de polarisation. Si nous introduisons dans la correction décrite par l'équation permettant la prise en considération de la contribution de la réflectivité de surface, la fluence locale absorbée après N impulsions devient alors:

$$F_{abs,N}(r) = F_N(r)(1 - R)\cos(\gamma(r)) \qquad (42)$$

Dans le cas du référentiel, nous utilisons (figure 18b), $\alpha = 90° - \gamma$. En général, pour les métaux, pour une faible conicité, c'est-à-dire pour une valeur élevée de a, la réflectivité p-polarisée devient faible et la transmission est améliorée, ainsi l'efficacité d'ablation est également améliorée pour une faible conicité. Pour le faisceau oblique, le même calcul peut être fait avec $\alpha$-$\beta$ au lieu de $\beta$. Avec une polarisation moyenne, l'effet est pris en compte avec un coefficient multiplicatif à $F_0(0)$ dans l'équation définissant la fluence locale après N impulsions en utilisant les équations relative à la réflectivité de $R_s$ et $R_p$. Ce coefficient est 1 pour la conicité supérieure à 20 °, et peut atteindre 1 pour la conicité inférieure à 20 ° en fonction également de la valeur de $\beta$.
En comparaison de ce qui est proposé dans l'état de la technique, la méthode de simulation de l'invention comprend que chaque matériau dont les paramètres d'intéraction laser matière ont été modélisé et ajouté à la base de données est analysé par ellipsométrie afin de déterminer son indice de réfraction complexe (n + ik) en fonction de la longueur d'onde du rayonnement laser.
Ainsi, la réflectivité est prise en compte comme suit:

- la réflectivité est calculé en tant que Rs, Rp ou (Rs + Rp) / 2 selon les formules de Fresnel des équation (38), (39), et (40), pour S, P ou polarisation circulaire, respectivement ;
- le R résultant, qui sera compris entre 0 et 1, est soustrait à la fluence d'incidence, donnant une fluence absorbée donnée par:

$$F_{absorbé}(y) = F_c(0) \times \sin(\gamma_n(y) + \beta) \times (1\text{-}R).$$

**Propagation de faisceau gaussien**

Puisque les traitements au laser sont généralement effectués avec le faisceau (gaussien) focalisé en utilisant une lentille avec une certaine distance focale, la propagation du faisceau doit être prise en compte car la plupart des expériences sont effectuées sans ajuster la distance de surface au plan focal. la profondeur d'ablation augmente. La variation du rayon du faisceau en fonction de la distance au plan focal est donnée par:

$$\omega(z) = \omega_0 \sqrt{1 + \left(\frac{z}{z_R}\right)^2} \qquad (43)$$

où $z_R$, est la distance Rayleigh, donnée par le relation :

$$z_R = \frac{\pi \omega_0^2}{\lambda} \qquad (44)$$

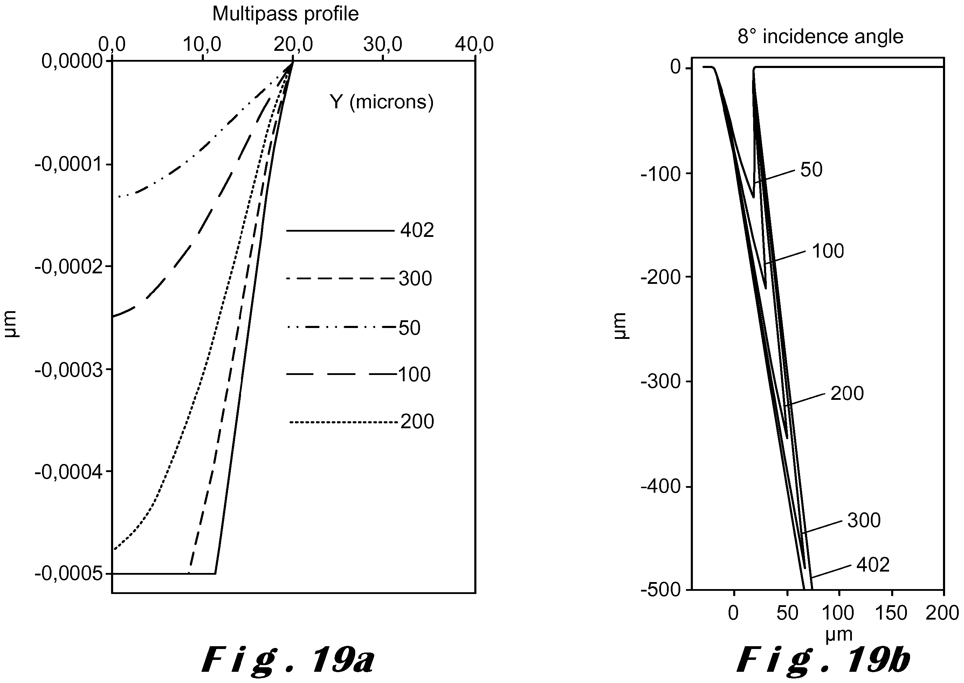

En cas d'incidence non normale, la distribution de la fluence en fonction de z et de la coordonnée radiale r peut être déterminée numériquement en appliquant une correction géométrique, schématisée à la figure 19. Le centre de la poutre avec un angle d'inclinaison $\alpha$ = 90 ° -$\beta$ peut être décrit comme suit :

$$z_R = r \, \tan(\beta) + f, \quad (45)$$

où f est la distance de la surface au plan focal. Par contre, la droite perpendiculaire à cet axe central du faisceau et passant dans le point générique P (r, z) est donnée par:

$$z_P = r \, \tan(\beta + 90°) + O_P \quad (46)$$

Pour déterminer la fluence au point générique P(r,z), il faut connaître la distribution gaussienne de l'intensité le long du plan $z_P$ et, à son tour, la distance entre le point BP(r, z) et le foyer f. Le point BP peut être calculé à partir de l'intersection des deux lignes $z_B$ et $z_P$ :

$$z_B = z_P \qquad (47)$$

$$Z_{BP} = r_{BP} \, \tan(\beta + 90°) + O_P \qquad (48)$$

$$O_P = z_{BP} - r_{BP} \tan(\beta + 90°) \qquad (49)$$

Les distances z' et r' peuvent alors être facilement obtenues à partir des coordonnées cartésiennes des points BP et P:

$$z' = \sqrt{(r_{BP})^2 + (z_{BP} - f)^2} \quad (50)$$

$$r' = \sqrt{(r_{BP} - r_P)^2 + (z_{BP} - z_P)^2} \quad (51)$$

A partir des deux distances z' et r', il est alors possible de calculer la fluence locale, en utilisant la largeur du faisceau sur ce plan décrit par la ligne $z_P$ :

$$F(z_P) = F_0 \exp\left(2\frac{r'^2}{\omega(z')}\right), \text{ où } \omega(z') = \omega_0\sqrt{1 + \left(\frac{z'}{z_R}\right)^2}. \quad (52)$$

Étant donné que les traitements au laser sont généralement effectués avec le faisceau (gaussien) focalisé à l'aide d'une lentille d'une certaine distance focale, il convient de tenir compte de la propagation du faisceau, car la plupart des expériences sont effectuées sans ajustement de la distance de surface au plan focal.alors que la profondeur d'ablation augmente. Contrairement à l'état de la technique, le modèle compris dans l'algorithme mis en oeuvre par l'unité centrale prend en compte la propagation du faisceau. La variation du rayon du faisceau en fonction de la distance au plan focal est donnée par:

$$\omega(z) = \omega_0\sqrt{1 + \left(\frac{z}{z_R}\right)^2} \quad (53)$$

où z_R, la distance de Rayleigh, est:

$$z_R = \frac{\pi\omega_0^2}{\lambda} \quad (54)$$

Par exemple, il en résulte le profil de distribution du faisceau suivant dans la zone du plan focal, pour un faisceau de 30 $\mu$m de diamètre au foyer et de 1030 nm de longueur d'onde. Dans ce cas, la distance de Rayleigh est de 686,27 $\mu$m.

**Simulation d'un usinage utilisant un faisceau laser en précession**

L'ablation laser par précession est une technique qui permet faire du perçage et découpe à flancs droits à haute vitesse, plus avantageuse et efficace que en utilisant par exemple une buse et un gaz ou en faisant balayer le faisceau à grande vitesse avec une tête scanner. Le mouvement en précession peut être obtenu en utilisant un miroir tournant ou tout autre élément tournant, dans le chemin optique du laser. Avec un miroir tournant, il est aiséde contrôler la vitesse de rotation du faisceau $\omega$ (en rpm), les positions du centre de rotation du faisceau BFG (best focus - global beam) et du plan focal du faisceau BFI (best focus - individual beams) par rapport à la surface, et l'angle d'attaque $\beta$.

Dans cette configuration d'ablation, la superposition d'impulsions va être différente par rapport à l'ablation produite par un faisceau balayé linéairement. Pour déterminer le profil d'ablation d'un trou percé, il faut connaître la distance entre spots dx, qui dépend du rayon de précession $r_P$, et l'angle $\theta$.

Le rayon de précession $r_P$ est donné par :

$$r_P = \left(\frac{BFG}{\cos\beta} - z\right)\tan\beta \quad (55)$$

où BFG est la distance au centre de rotation du faisceau, $\beta$ est l'angle d'attaque et z est la distance à la surface du matériau.

La distance entre deux impulsions consécutives dx peut être calculé comme la distance entre deux sommets d'un polygone avec NR côtés (eq. 57), NR étant le nombre total d'impulsions pendant une révolution. NR dépend du taux de répétition d'impulsions PRR (Hz) et de la vitesse de rotation $\omega$ (rpm) (eq. 56).

$$NR = \frac{PRR}{\omega/60} \quad (56)$$

$$dx = 2r_P\sin\left(\frac{n\theta}{2}\right) \quad (57)$$

Ainsi, il y a superposition entre impulsions si la distance dx entre la première impulsion $n_0$ et l'impulsion $n_N$ est inferieure au rayon d'un cratère ablaté ($r_c$), qui est donnée par :

$$r_c = w_0\sqrt{\ln\left(\frac{F_0}{F_{th}}\right)} \qquad (58)$$

Finalement, la profondeur d'ablation produit par chaque impulsion n pendant une révolution, en fonction de la distance au centre y est donnée par :

$$z_n = -\delta\left[\ln\left(\frac{F_0}{F_{th}(n+NR/2)}\right) - 2\frac{n^2dx^2}{w^2} - 2\left(\frac{(y+y_c)^2}{w^2}\right)^p\right] \qquad (60)$$

où $\delta$ est la profondeur de pénétration de la radiation dans le matériau, $F_0$ la fluence maximale, $F_{th}$ le seuil d'ablation, w est le rayon du faisceau Gaussien et p est l'ordre de la Gaussienne. Cette profondeur doit être itéré R fois, où R est le nombre total de révolutions, donné par :

$$R = proc.time * \omega/60. \qquad (61)$$

où proc.time est le temp d'usinage total. Il faut noter aussi que le rayon du faisceau Gaussien dépend de la distance au point focal BFI. Dans les équation décrite ci-dessus, il est important de remarquer les éléments suivant : le w va changer au fur et à mesure de la profondeur d'usinage. Après chaque ipulse le $r_P$ va varier si une partie du l'usinage a déjà été ablétée.

De préférence, les formules décrites ci-avant peuvent être utilisées individuellement ou en combinaison pour mettre en oeuvre un algorithme pour la simulation un profil d'usinage en deux et ou trois dimensions.

**Brève description des figures**

Ces aspects ainsi que d'autres aspects de l'invention seront clarifiés dans la description détaillée de modes de réalisation particuliers de l'invention, référence étant faite aux dessins des figures, dans lesquelles:

- la Fig.1 représente les principales caractéristiques d'un faisceau ayant un profil d'intensité gaussien ;
- la Fig.2 représente une matrice de cratères avec des nombres d'impulsions et des énergies d'impulsion croissants ;
- les Fig.3a - Fig.4b représentent : Fig.3a et Fig.4a, une pluralité d'impulsion selon un ligne ; Fig.3b, un profil de fluence obtenu transversalement à la ligne décrite dans la Fig.3a ; Fig.3c représente une distribution du nombre d'impulsion N transversalement à la ligne décrite en Fig.3a ; Fig.4b, la profondeur de sillon obtenue transversalement à la ligne décrite par la Fig.4a ;

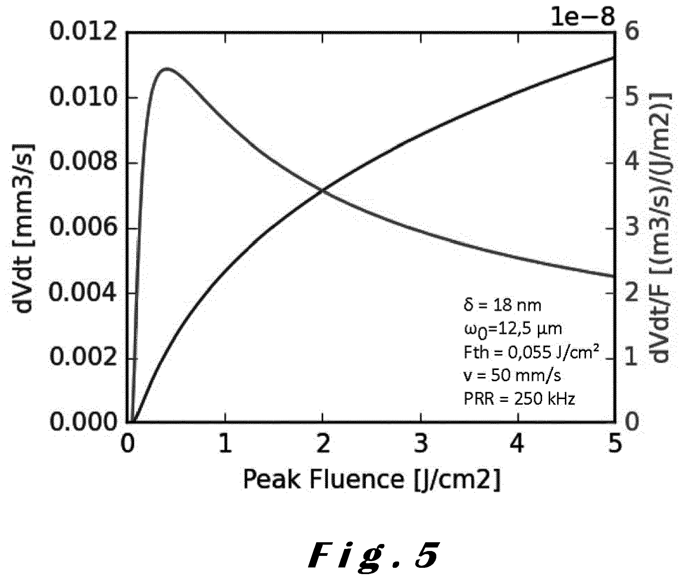

- la Fig.5 montre des résultats de simulation obtenus pour une coupe transversale d'une ligne représentant un taux d'ablation (à gauche) et un taux d'ablation maximal en fonction de la fluence du laser ;
- les Fig.6a et 6b représentent en Fig.6a le déplacement de l'échantillon dans la direction des axes Y et Z pour la mise en oeuvre de la méthode D-Scan et en Fig.6b les lobes d'ablation résultants de la mise en oeuvre du protocole expérimental de la Fig.6a. ;
- les Fig.7a et 7b montre une représentation schématique des expériences à faire pour estimer la valeur de $\delta$ selon la méthode du skin depth ;
- les Fig.7c et 7d montrent les résultats expérimentaux comparés aux modèles pour les expériences représentées en Fig.7a et 7b respectivement ;
- les Fig.8a et 8b montrent les résultats concernant les dimensions $\rho_{min}$ et $\rho_{max}$ issus des expériences décrites en Fig.7a et 7b pour des fréquences d'impulsion de faisceau laser de 5 KHz et 100 KHz respectivement. La Fig.9 montre les résultats des expériences à 5 KHz et à 100 KHz des figures 8a et 8b dans un graphique montrant la fluence $F_{th}$ en fonction d'un nombre d'impulsion N ;
- la Fig.10 montre une simulation de l'ablation mesurée en fonction de l'angle d'incidence pour une polarisation S à gauche et P à droite ;
- la Fig. 11 représente la propagation d'un faisceau Gaussien et représente le diamètre du faisceau $w$ en fonction d'une distance de propagation *z* ;

- les Fig.12 et 13 représentent des résultats expérimentaux et issus de simulations pour deux valeurs de $\delta$. La figure 12 représente la profondeur maximale en fonction de la fluence de faisceau. La Figure 13 représente la profondeur maximale en fonction d'une vitesse de balayage du faisceau ;
- les figures 14a, 14b 15a, 15b et 15c représentent des profils expérimentaux et simulés obtenus sur acier inox 316L ;
- les Fig.16a et 16b montrent en Fig.16a une section transversal d'un balayage et le correspondant simulé (Fig.16b) obtenu sur acier inox 316L J
- les Fig.17a et 17b montrent une représentation schématique d'un usinage avec un angle d'incidence normal en Fig.17a et un usinage avec un angle d'incidence non-normal en Fig.17b ;
- la Fig.18 montre une représentation schématique des angles d'un faisceau lumineux lors d'expériences pour le calcul de la fluence locale sous une incidence non-normale ;
- les Fig.19a et 19b montrent un exemple comparatif entre une simulation d'un profil d'usinage selon l'état de la technique (Fig. 19a) et une simulation selon un mode de réalisation particulier de la méthode de l'invention pour un usinage réalisé avec un faisceau laser d'usinage ayant un angle d'attaque non nul avec la normale à la surface du matériau à usiner.
- la Fig. 20a montre une représentation schématique d'un usinage avec un faisceau d'usinage laser en procession ;
- les Fig. 20b, 20c, 21b et 21d montrent des simulations d'usinage selon un mode de réalisation particulier de la méthode de l'invention ;
- les Fig. 21a et 21c montrent des résultats d'usinages sous la forme d'images de coupe transversales d'un usinage, les simulations d'usinage illustrées en Fig. 21b et Fig. 21c sont superposées aux résultats d'usinages respectivement ;
- la Fig. 22a montre une représentation schématique des points d'impact d'un faisceau laser d'usinage en précession ou en rotation, la Fig. 22b montre un détail de la Fig. 22a ;
- les Fig.23 à 31 représentent des organigrammes de modes de réalisations préférés de l'invention.

Les dessins des figures ne sont pas à l'échelle. Généralement, des éléments semblables sont dénotés par des références semblables dans les figures. La présence de numéros de référence aux dessins ne peut être considérée comme limitative, y compris lorsque ces numéros sont indiqués dans les revendications.

**Exemple de dispositif expérimental pour mettre en oeuvre la méthode de l'invention**

Les expériences réalisées pour confronter les modèles décrit ci-dessus ont été réalisées sur des échantillons d'acier inoxydable poli 316L et 316 et TiCr6Sn4. Les tests ont été réalisés dans l'air en utilisant un laser femtoseconde Satsuma HP2 (Amplitude Systèmes) avec une durée d'impulsion d'environ 330 fs, une longueur d'onde de rayonnement de 1030 et une puissance maximale de 20 W à 500 kHz. Le faisceau a été focalisé à la surface des échantillons en utilisant une lentille télécentrique de focale de 100 mm, produisant un rayon de spot d'environ 10 $\mu$m déterminé en utilisant la méthode $D^2$.

L'analyse morphologique et topographique des échantillons traités a été réalisée à l'aide d'un microscope optique confocal (Olympus LEXT OLS4100).

La méthode $D^2$ a été utilisée pour calculer les valeurs de fluence de seuil (Fth). Pour déterminer la valeur de $\delta$, plusieurs balayages de ligne avec une énergie d'impulsion croissante ont été produits et leurs profondeurs mesurées. La valeur $\delta$ appliquée dans le modèle a été variée jusqu'à ce que la meilleure correspondance avec les résultats expérimentaux ait été obtenue.

De préférence, plus la quantité de résultats fournis à la base de donnée est grande plus les paramètres d'usinage laser sont déterminer avec précision.

**Description détaillée de certains modes de réalisation de l'invention**

La figure 1 montre un profil d'intensité d'un faisceau laser de type gaussien. Le centre du faisceau est définie par la valeur 0 selon l'axe des abscisse définissant un rayon de faisceau r et une intensité maximale $I_0$ est observée au centre du faisceau. Un rayon de faisceau $\omega_0$ par rapport au centre du faisceau est défini pour une valeur d'intensité de faisceau égale à $I_0/2$.

La figure 2 montre une matrice de cratère à usiner afin de pouvoir mettre en oeuvre la détermination du seuil d'ablation par la méthode $D^2$. La figure 2 décrit un mode de réalisation préféré pour produire une matrice de cratère avec la machine d'usinage laser de l'invention. La matrice représentée en Figure 2 montre un nombre d'impulsion pour chacune des colonnes compris entre 10 et 110 et des énergies de faisceau comprises entre 10% et 100% d'une valeur de faisceau maximale pouvant être fournie par la machine d'usinage laser de l'invention. La réalisation d'une telle matrice de cratères en respectant les énergies de faisceau et les nombres d'impulsions indiquées suivie de la caractérisation topologique et ou dimensionnelle des cratères de cette matrice permet ainsi de définir un seuil d'ablation, un coefficient d'incubation ou encore un rayon du faisceau. De préférence la production de la matrice de cratère doit être réalisée avec des nombres d'impulsions et des énergies d'impulsion croissants, comme illustré par les flèches en Figure 2. Pour avoir des points expérimentaux suffisants, il faut avoir au moins 20 valeurs d'énergie, et plusieurs valeurs de nombre d'impulsions inférieur à 100 impulsions. Le diamètre de chaque cratère peut être mesuré à partir d'images obtenues avec un microscope optique ou électronique ou un profilomètre.

La figure 3a montre une pluralité d'impulsion selon un ligne. Une impulsion est représentée par un cercle ayant son centre sur une ligne. Les centres de chaque cercles, c'est-à-dire les points où l'intensité maximale de chaque impulsion est maximale $I_0$ sont distant selon une ligne de : $\Delta x = v/PRR$. v étant la vitesse de déplacement du faisceau et PRR étant un nombre d'impulsion par unité de temps. La Figure 3a montre que pour des impulsions selon une ligne, avec une distance entre chaque cercle inférieure au rayon de chaque cercle, alors statistiquement, plus d'impulsions parviennent au centre de la ligne que sur le bords de la ligne.

La figure 3b montre un profil de fluence obtenu transversalement à la ligne décrite dans la figure 3a. Ce profil de fluence montre que la fluence au centre de la ligne est beaucoup plus élevée que sur les bords de cette ligne.

La figure 3c montre une distribution du nombre d'impulsion N transversalement à la ligne décrite en figure 3a. Comme anticipé dans la description de la figure 3a, statistiquement, un plus grand nombre d'impulsions atteint le centre de la ligne que les bords de la ligne.

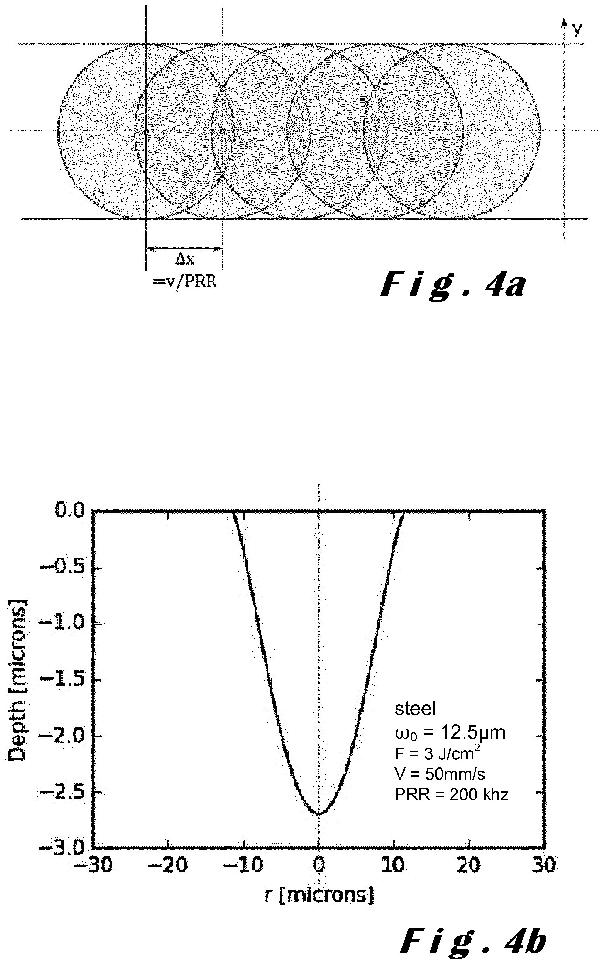

La figure 4a montre comme la figure 3a une pluralité s'impulsions le long d'une ligne. La figure 4b, montre la profondeur de sillon obtenue transversalement à la ligne décrite par la Figure 4a avec les paramètres expérimentaux suivants :

- matériau : acier ;
- $\omega_0$=12.5$\mu$m ;
- F =3 J/cm$^2$ ;
- V = 50 mm/s ;
- PRR = 200 kHz.

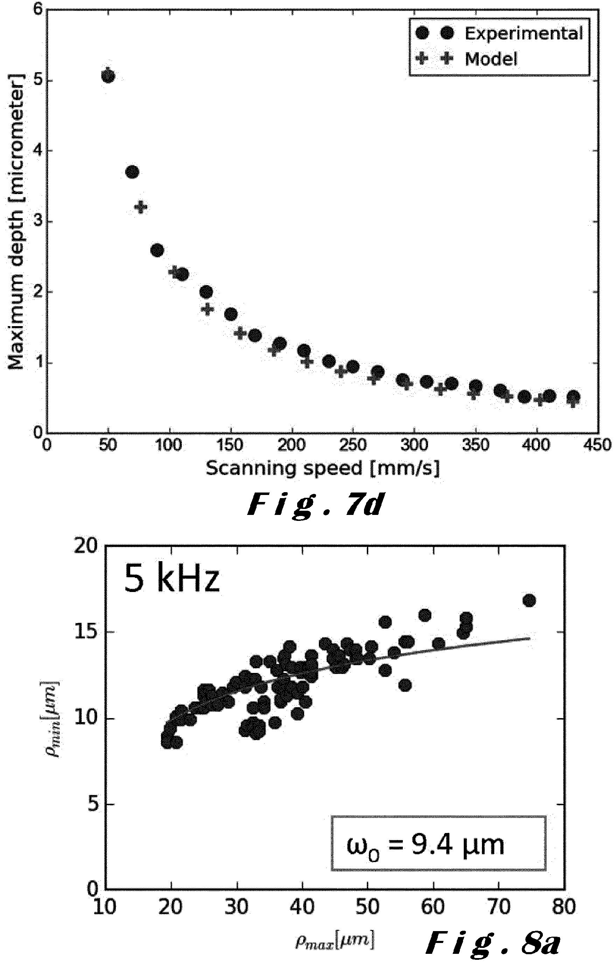

Les Figures 7c et 7d représentent les résultats expérimentaux comparés aux modèles correspondants obtenus par les expériences décrites en Figures 7a et 7b. La Figure 7c montre les profondeurs maximales des balayages obtenus sur un substrat en acier en fonction de la fluence maximale. La Figure 7d montre les profondeurs maximales des balayages obtenus sur un substrat en acier en fonction de la vitesse de décalage ou vitesse de balayage.

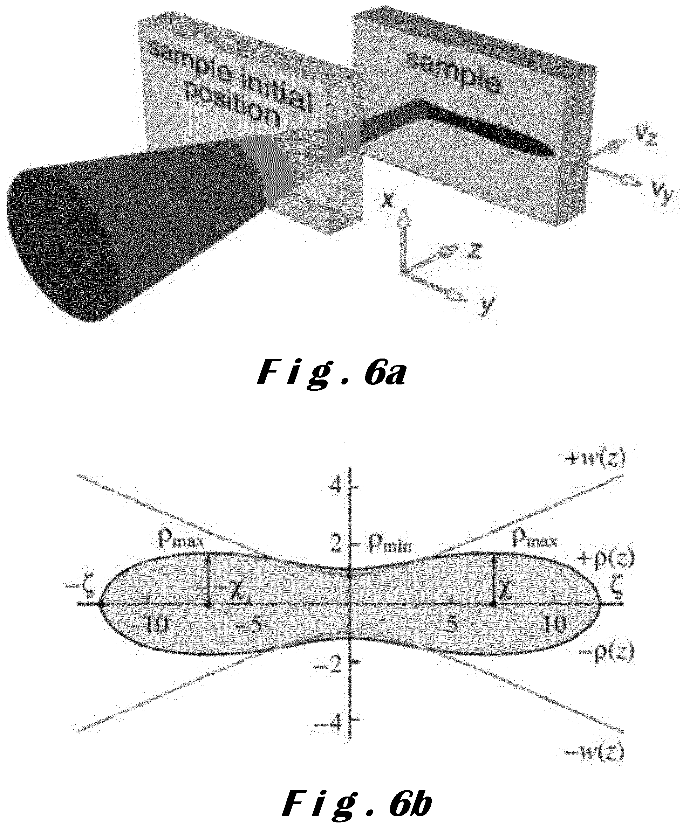

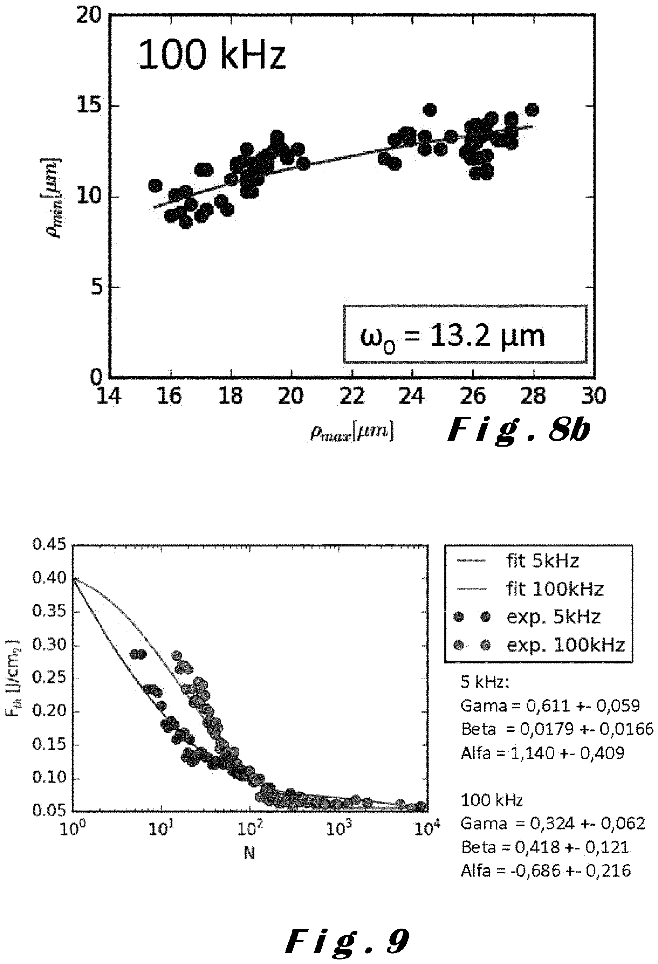

Les Figures 8a et 8b montrent des nuages de points obtenus pour des expériences décrites en Figures 6a et 6b pour lesquels une régression selon un algorithme de l'invention permet de déterminer le paramètre $\omega_0$.

La figure 9 montre les résultats expérimentaux de la méthode D-scan pour deux fréquences d'impulsions de 5 KHz et de 100 KHz. Les régressions concernant ces deux séries de résulats expérimentaux sont également illustrées par les lignes. Les paramètres de ces deux régressions sont indiqués par Gama, Beta et Alfa.

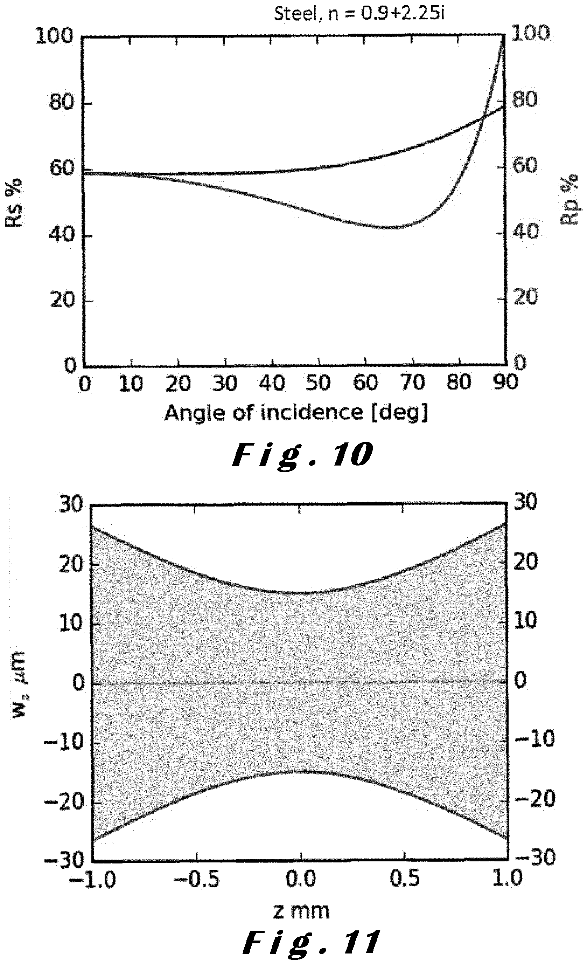

La figure 10 représente un paramètre d'intéraction d'un faisceau lumineux polarisé avec un substrat d'acier ayant les propriétés suivantes : n = 0,9 + 2,25i. La figure 10 montre le paramètre di'ntéraction pour des angles d'incidence compris entre 0° et 90°, pour une polarisation s et pour une polarisation p. La courbe représentant la polarisation p est celle présentant un maximum à 100% pour un angle d'incidence de 90°.

La figure 11 montre une simulation de la largeur du faisceau $w_z$ au niveau de sa largeur minimale. La largeur minimale du faisceau est indiquée à une distance $z$ selon une direction de propagation $z$ ayant une valeur à 0. Le profil de faisceau ainsi simuler montre la divergence du faisceau selon la direction $z$.

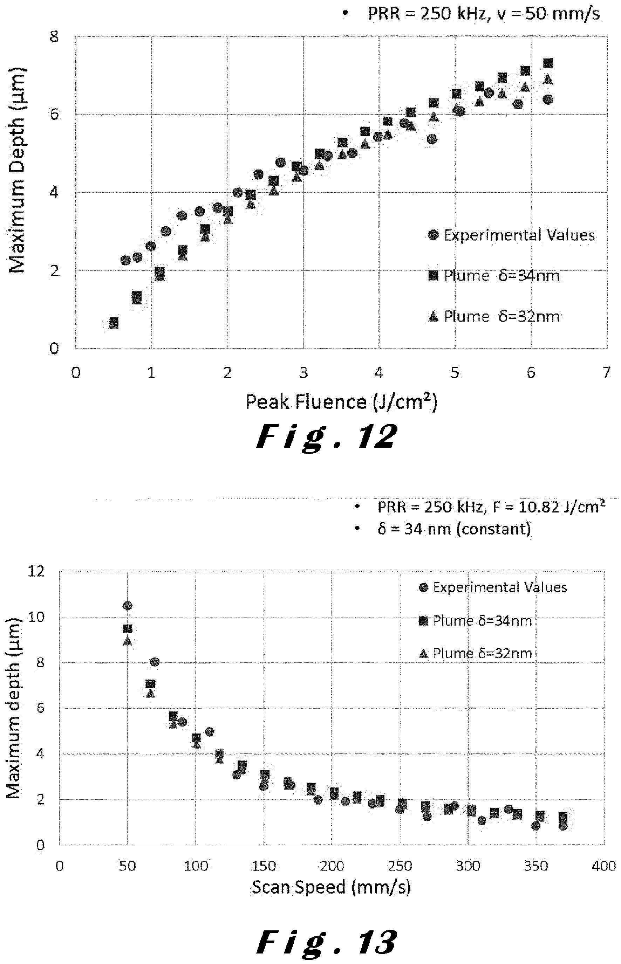

La figure 12 montre des résultats expérimentaux et des simulations pour deux valeurs de $\delta$, concernant la profondeur maximale en fonction de la fluence de faisceau. Pour des valeurs de peak fluence inférieures à 2 J/cm$^2$ et supérieures à 4,5 J/cm$^2$, les résultats expérimentaux varient des deux simulations ayant pour valeur de $\delta$ de 32 nm et 34 nm. Cette figure illustre très bien la nécessité d'avoir un algorithme de simulation suffisament complet de sorte à bien prendre en compte un maximum de paramètres liés à l'usinage. Ainsi, une bonne prose en compte des paramètres d'intéraction laser matière permet d'obtenir une bonne correlation entre un résultat d'usinage et les prédiction d'une simulation pour un delta constant.

La Figure 13 représentant la profondeur maximale en fonction d'une vitesse de balayage du faisceau montre une bonne corrélation entre les résultats expérimentaux d'ablation et la vitesse de balayage du faisceau. Les résultats expérimentaux montrent également une relativement bonne robustesse lors de la variation du paramètre de $\delta$ de 32 nm et 34 nm.

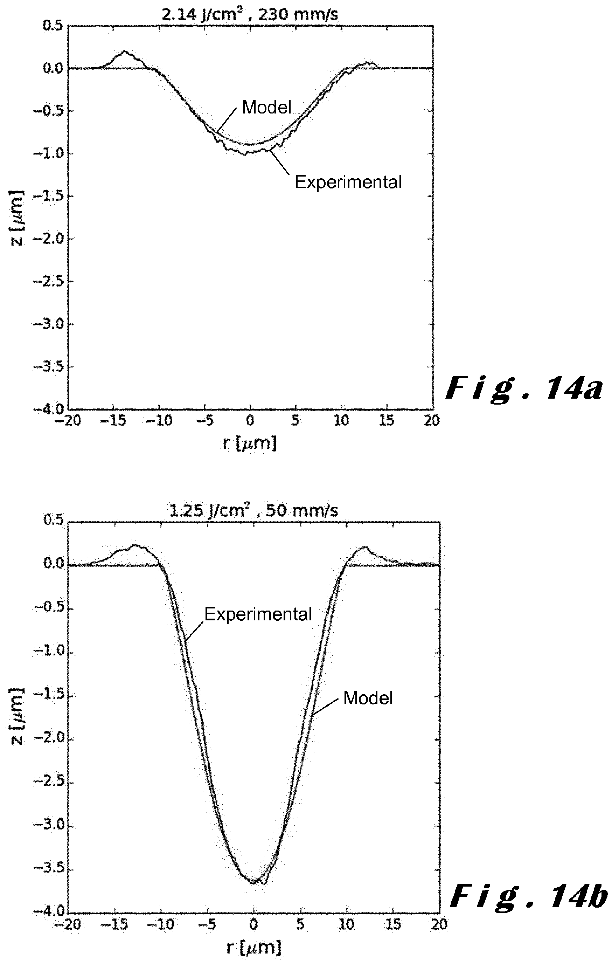

Les figures 14a et 14b représentent des profils expérimentaux et simulés obtenus sur acier inox 316L avec une fluence maximale de 2.14 J/cm$^2$, vitesse de balayage 230 mm/s (Fig.14a) et 1.25 J/cm$^2$ et vitesse de balayage de 50 mm/s (Fig.14b, polarisation p et fréquence de 250 kHz). Une bonne correspondance entre résultats expérimentaux et résultats simulés est observée concernant la profondeur maximale de l'ablation ainsi que le profil de l'ablation. En revanche, la redéposition de matière sur les bords de l'ablation n'est pas prise en compte par la simulation. La méthode de simulation de l'invention pourrait permettre une prise en compte de la redéposition de matière sur les bords de l'ablation réalisée expérimentalement par le dévelopement d'un algorithme adapté.

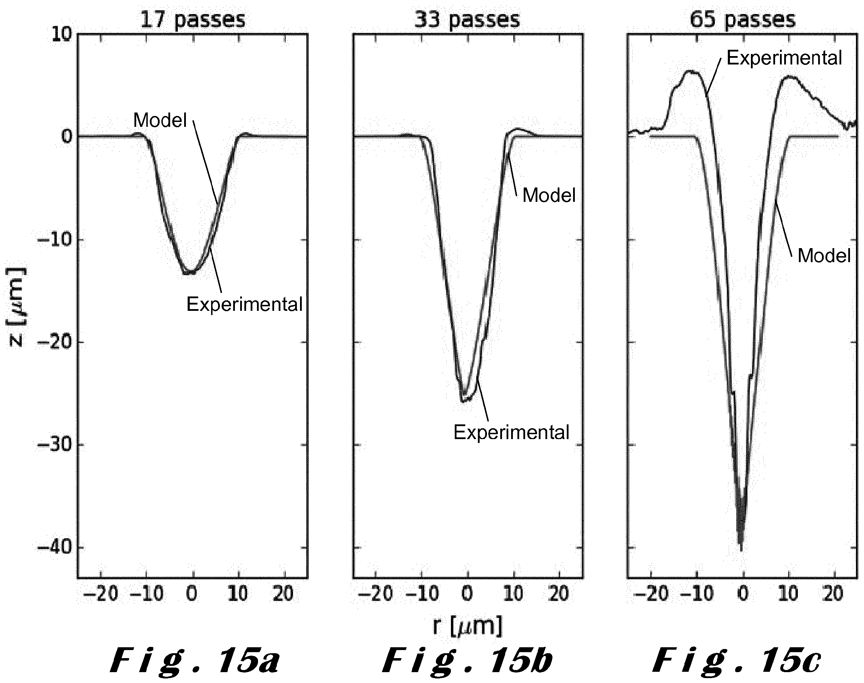

Les figures 15a, 15b et 15c représentent des profils expérimentaux et simulés obtenu sur acier inox 316L avec une fluence maximale de 1.92 J/cm$^2$, vitesse de balayage 100 mm/s, fréquence de 100 kHz, la Fig.15a est obtenus après 17 balayages, la Fig.15b après 33 balayages et la Fig.15c après 65 balayages. Les mêmes observations que concernant les Figures 14a et 14b peuvent être observées.

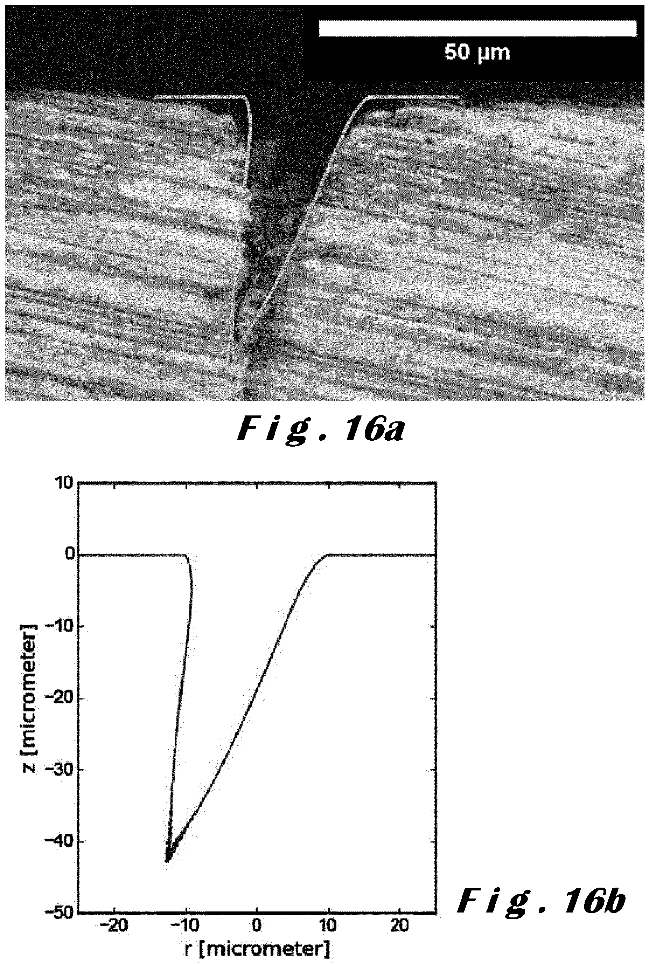

Les Figures 16a et 16b montrent en Fig.16a une section transversal d'un balayage et le correspondant simulé (Fig.16b) obtenu sur acier inox 316L avec une fluence maximale de 2.9 J/cm$^2$, vitesse de balayage 500 mm/s, fréquence de 100 kHz et 500 passages avec le faisceau incliné 15° par rapport à la normale à la surface. Le modèle de l'invention permet une bonne prise en compte de l'angle d'incidence du faisceau incident sur le matériau à usiner. Comme le démontre la figure 16a, une bonne correspondance entre la micrographie de l'usinage (ablation) et la simulation qui est superposée.

Les figures 17a et 17b montrent des profils d'usinages obtenus avec un angle d'incidence normal à la surface de la pièce à usiner et avec un angle d'incidence décrivant un angle 90°-$\beta$ par rapport à la surface de la pièce à usiner. Par exemple ces représentation schématique avec des angles d'incidences différents par rapport à la suface de la pièce à usiner permettent de calculer la fluence locale.

La Figure 18 montre une représentation schématique des angles d'un faisceau lumineux lors d'expériences pour le calcul de la fluence locale sous une incidence non-normale. En particulier, cette représentation schématique illustre la divergence du faisceau ayant une incidence non-normale avec un substrat à usiner. Les particularité qu'engendre cette divergence du faisceau focalisé sont ainsi illustrées.

Les Fig.19a et 19b montrent un exemple comparatif entre une simulation d'un profil d'usinage selon l'état de la technique (Fig. 19a) et une simulation selon un mode de réalisation particulier de la méthode de l'invention (Fig. 19b) pour un usinage réalisé avec un faisceau laser d'usinage ayant un angle d'attaque non nul avec la normale à la surface du matériau à usiner. Pour les deux Fig. 19a et 19b, il s'agit de profils multipasses obtenus sur acier inoxydable (dans les deux cas $\delta$ = 32 nm, $F_{th}(1)$ = 0,1 J/cm$^2$, S = 0,8, n = 0,9-2,25i) pour $w_0$ = 14 $\mu$m, PRR = 200 kHz, $\Delta$x = 0,75 $\mu$m , $F_0$ = 8 J / cm$^2$ et un angle d'incidence de 8°. Les indications chiffrées dans les figures indique le nombre de passe du faisceau laser d'usinage pour chacun des profil d'usinage à deux dimensions simulés. Les simulations ont donc réalisé pour 50, 100, 200, 300, 402 passes. Le mode de réalisation particulier de l'invention qui permet le traitement de faisceaux laser d'usinage ayant un angle non-nul par rapport à la surface du matériau permet une simulation très représentative de ce que serait l'usinage en utilisant les mêmes paramètre laser. Dans le cas de la simulation utilisant les méthodes de l'état de la technique, on observe qu'un nombre élevé permet d'approcher un flanc d'usinage perpendiculaire à la surface du matériau mais sans jamais l'atteindre, ce qui est problématique pour la simulation d'usinage avec une conicité des flancs par rapport à la surface du matériau bien controlée. En effet, les modules de précession ou autres modules de faisceau laser d'usinage permettant l'usinage avec un angle de faisceau bien controlé nécessite des outils de simulation adaptés. Le mode de réalisation particulier de l'invention semble en est un. L'axe des ordonnées des Figs. 19a et 19b représente une profondeur d'ablation simulée exprimée en $\mu$m. L'axe des abscisses des Figs. 19a et 19b représente une dimension y correspondant à une dimension parallèle à la surface du matériau à usiner.

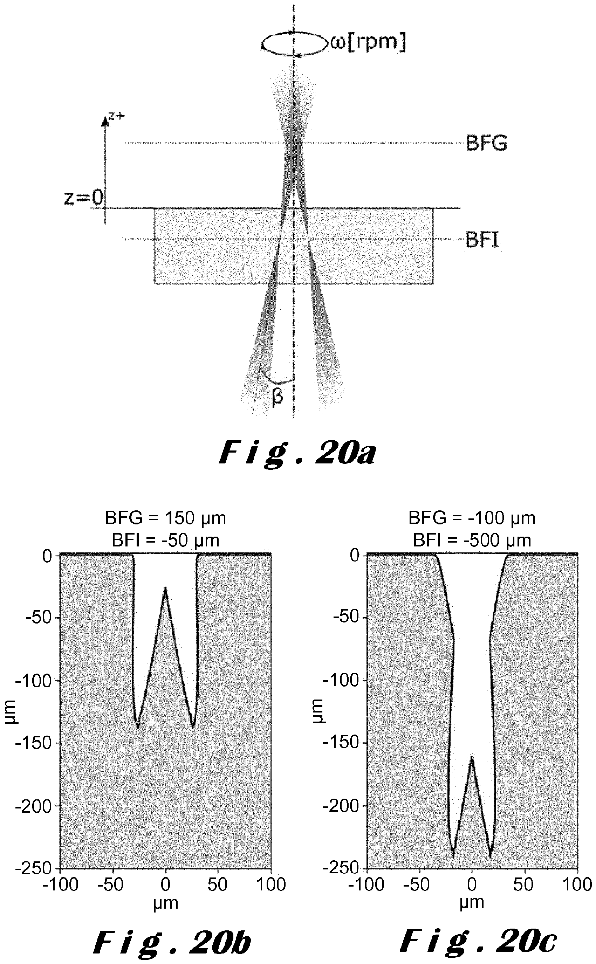

La Fig. 20a montre une représentation schématique d'un usinage avec un faisceau d'usinage laser en precession. Il est ainsi illustré, un matériau à usiné dont la surface correspond à la coordonné z=0 par rapport à l'axe z essentiellement perpendiculaire à la surface du matériau. Le faisceau laser en rotation, plus particulièrement en précession comme indiqué par la flèche circulaire indiquant un sens de rotation. Le faisceau provient du coté de cette flèche circulaire et est dirigé vers le matériau à usiner. Le faisceau laser d'usinage est représenté comme traversant le matériau de sorte à illustré la trajectoire du faisceau laser en precession. Ainsi le faisceau laser décrit un point BFG situé sur un plan BFG essentiellement parallèle à la surface du matériau. Comme on peut l'observer, le faisceau en précession passe toujours par le même endroit au point BFG. Par ailleurs, le plan BFI est le plan dans lequel le faisceau laser en precession est focalisé. Le faisceau laser en precession tourne autour d'un axe représenté comme confondu à la normale à la surface du matériau. Le faisceau laser en precession décrit donc un angle $\beta$ pour toutes les positions de précession du faisceau par rapport à l'axe de rotation du faisceau.

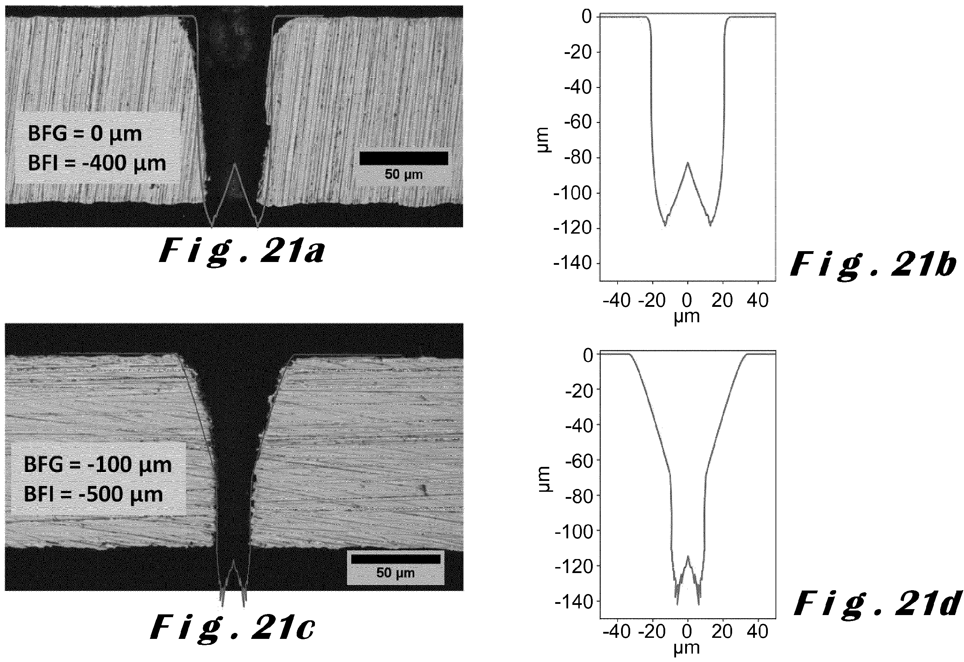

Les Fig. 20b, 20c, 21b et 21d montrent des simulations d'usinage selon un mode de réalisation particulier de la méthode de l'invention pour un faisceau laser en précession tel qu'illustré schématiquement en Fig. 20a. Les Figs. 20b, 20c, 21b et 21d montrent des profils d'usinage en deux dimensions, selon les axes y, z, les axes des ordonnées représentant la dimension z (profondeur d'ablation) et les axes des abscisses représentant la dimension y. La Fig. 20b correspond à une simulation selon le mode de réalisation particulier de la méthode de l'invention permettant la simulation d'un faisceau d'usinage laser en precession avec BFG = 150 $\mu$m et BFI = -50 $\mu$m. De même, la Fig. 20c a été obtenue avec un BFG = -100 $\mu$m et BFI = -500 $\mu$m. Les simulations des Fig. 20b et 20c ont été obtenus avec les paramètres laser : $w_0$ = 10 $\mu$m, PRR = 500 kHz, $E_p$ = 20 $\mu$J, $\omega$= 30 000 tpm, $\beta$ = 4,5°, temps d'usinage = 50 ms. La Fig. 21b correspond à une simulation selon le mode de réalisation particulier de la méthode de l'invention permettant la simulation d'un faisceau d'usinage laser en procession avec BFG = 0 $\mu$m et BFI = -400 $\mu$m. De même, la Fig. 21d a été obtenue avec un BFG = -100 $\mu$m et BFI = -500 $\mu$m. Les simulations des Fig. 21b et 21d ont été obtenu avec les paramètres laser : $w_0$ = 12 $\mu$m, PRR = 100 kHz, $E_p$ = 27 $\mu$J, $\omega$= 30 000 tpm, $\beta$ = 4,5°, temps d'usinage = 50 ms.

Les Fig. 21a et 21c montrent des résultats d'usinages sous la forme d'images de coupe transversales d'un usinage, les simulations d'usinage illustrées en Fig. 21b et Fig. 21c sont superposées aux résultats d'usinages respectivement. Il est ainsi observé que les simulations des usinages permettent une bonne anticipation des usinage obtenus sur la base des même paramètres pour un faisceau d'usinage laser en precession.

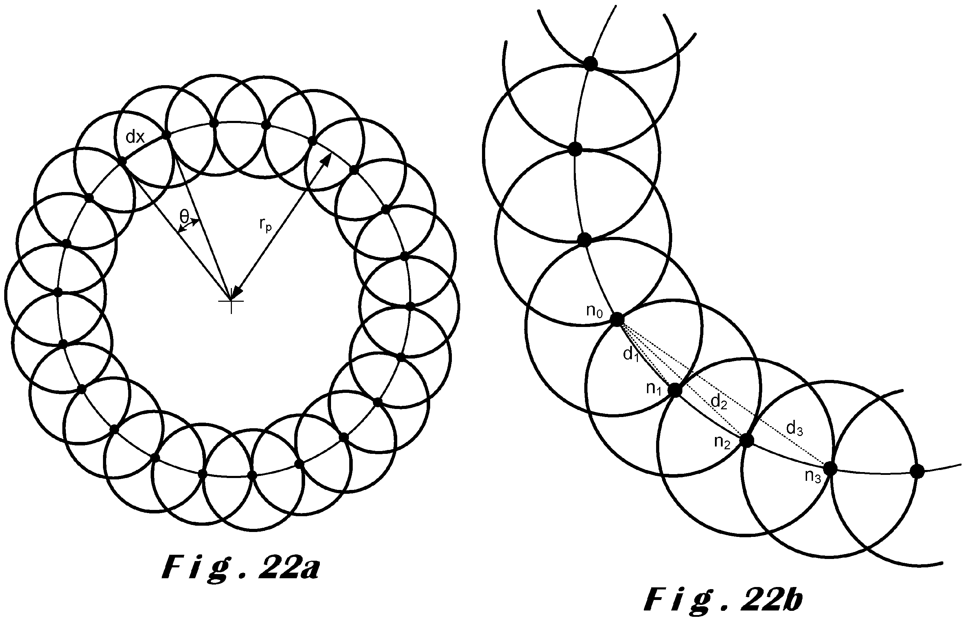

La Fig. 22a montre une représentation schématique des points d'impact d'un faisceau laser d'usinage en précession ou en rotation, la Fig. 22b montre un détail de la Fig. 22a. La Fig 22a, illustre la superposition d'impulsions d'un faisceau d'usinage laser en précession. Autour d'un axe représenté ici par un point car il s'agit d'une projection des impulsions laser dans un plan, de préférence sur la surface du matériau. L'axe de rotation du faisceau laser en precession est donc perpendiculaire à la surface du matériau et donc représenté par un point. Chaque cercle représente une impulsion. Le centre de chaque impulsion est situé sur un cercle de precession centré sur l'axe de rotation du faisceau laser d'usinage. Le cercle de precession a un rayon $r_p$. La distance entre le centre de chaque cercle adjacent situé sur le cercle de précession est dx. De préférence dx est constante lors d'un usinage. Le centre de chaque cercle adjacent décrit un angle $\theta$ par rapport à l'axe de précession. La Fig. 22b représente une vue détaillée de Fig. 22a dans laquelle, le centre des cercles correspondant à une impulsion est nommé $n_0$, $n_1$, $n_2$, $n_3$, ... La distance entre $n_e$ et $n_1$ est $d_1$, la distance entre $n_0$ et $n_2$ est $d_2$, la distance entre $n_0$ et $n_3$ est $d_3$.

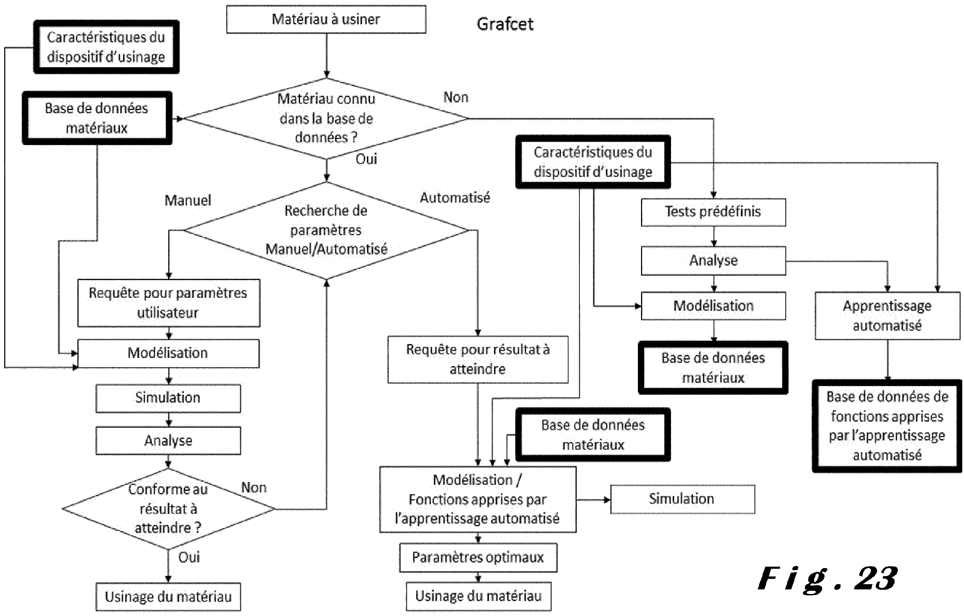

Les figures 23 à 31 représentent des organigrammes décrivant les différents éléments d'un système d'usinage laser ainsi que les étapes ou décisions possibles pouvant être prises. En particulier ces organigrammes montrent les moyens permettant le cheminement des informations et permettant d'aboutir à l'usinage d'un matériau avec des paramètres optimums ou encore permettant d'enrichir une base de données matériaux et ou de fonctions apprises par un apprentissage automatisé.

La figure 23 représente un Graphe Fonctionnel de Commande des Étapes et Transitions (Grafcet) ou organigramme fonctionnel des différentes actions disponibles selon l'invention. En particulier, cet organigramme montre que la méthode de l'invention peut décider, dans le cas où les paramètres d'un matériau ne serait pas disponible dans une base de données, de recourir au lancement d'un usinage de test prédéfini afin de permettre l'acquisition de données relative audit matériau à usiner.

La figure 23 illustre le cheminement suivant : un matériau à usiner est communiqué au système d'usinage laser qui lance une requête afin de savoir si des informations concernant ce matériau sont présente dans une base de données matériau ou dans une base de données de fonctions apprises. Dans le cas d'une réponse positive, il est alors possible de choisir entre une détermination des paramètre d'usinage de façon manuelle ou de façon automatisée.

Dans le cas d'une détermination des paramètres d'usinage de façon automatisée, le système d'apprentissage envoi une requête pour connaitre le résultat d'usinage à atteindre. Ce résultat à atteindre peut également être communiqué au moment où le matériau à usiner est communiqué. Sur la base du résultat à atteindre (résultat cible) définit par l'utilisateur, le système d'usinage laser et en particulier l'unité centrale d'apprentissage collecte des informations concernant les caractéristiques du dispositif d'usinage ainsi que les informations disponible dans l'une des bases de données concernant les information du matériau à usiner. L'unité centrale d'apprentissage permet alors l'exploitation des moyens permettant la modélisation et ou l'apprentissage automatisé en prenant en compte les informations du matériau à usiner, les caractéristiques du dispositif d'usinage et le résultat d'usinage à atteindre. L'unité centrale d'apprentissage peut alors générer des paramètres optimaux d'usinage. Ces paramètres optimaux d'usinage sont ensuite transmis au dispositif d'usinage laser afin de démarrer l'usinage laser du matériau à usiner selon le résultat à atteindre. Il est possible que l'unité centrale d'apprentissage soit relié au dispositif d'usinage laser par une connexion réseau de sorte que l'unité centrale d'apprentissage puisse être délocalisée par rapport au dispositif d'usinage laser.

Dans le cas d'une détermination de paramètres d'usinage de façon manuelle, l'unité centrale envoi une requête de sorte à obtenir de la part de l'utilisateur, des paramètres permettant d'obtenir un résultat à atteindre. De préférence les paramètres transmis par l'utilisateur sont les paramètres que l'utilisateur pense être les résultats optimaux. Cependant plusieurs itérations sont souvent nécessaire pour que l'opérateur dus sytème d'usinage laser spécifie des paramètres permettant d'obtenir un usinage conforme au résultat à atteindre. Lorsque des paramètres sont communiqués par l'utilisateur, alors des moyens de modélisation sont mis en oeuvre. Les moyens de modélisation comprennent de préférence une modèle comprenant un algorithme permettant un estimation de l'usinage sur la base des paramètres fournis. Ainsi des moyens de simulation couplés aux moyens de modélisation permettent de réaliser une simulation du résultat que l'on s'attend à obtenir sur la base des paramètres communiqués. L'opérateur peut alors comparer la simulation du résultat sur la base du paramètre avec le résultat à atteindre. Si l'opérateur estime que la simulation n'est pas conforme (ou suffisament conforme) au résultat à atteindre et le communique à l'unité centrale, alors l'unité centrale repropose de choisir entre une détermination des paramètre d'usinage de façon manuelle ou de façon automatisée. L'opérateur peut alors décider de tester en manuel plusieurs paramètres d'usinage différents jusqu'à ce qu'une simulation du résultat que l'on s'attend à obtenir sur la base des paramètres communiqués soit conforme au résultat à atteindre. Lorsque l'opérateur est satisfait de la simulation du résultat (usinage) que l'on s'attend à obtenir sur la base des paramètres communiqués alors il peut décider de démarrer l'usinage sur la base des paramètres ayant servi à la dernière modélisation et simulation. L'opérateur peut choisir à tout moment, de recourir à la recherche de paramètres de façon automatisé de sorte que le système d'usinage laser fait appel au mode automattisé tel que décrit ci-avant. L'unité centrale envoi alors une requête pour connaitre le résultat d'usinage à atteindre et détermine les paramètres d'usinage optimaux tels que décrit ci-avant et tel que représenté par l'organigramme. Lors de l'étape de modélisation en mode manuel, les moyens de modélisation ont accès à la base de données matériaux ainsi qu'aux caractéristique du dispositif d'usinage.

Dans le cas d'une réponse négative à la requête permettant de savoir si des informations concernant le matériau à matériau sont présentes dans une base de données matériaux ou dans une base de données de fonctions apprises, le système d'usinage laser défini alors des tests prédéfinis d'usinage. Ces tests prédéfinis d'usinage permettent au système d'usinage laser de produire un usinage prédéfini sur un matériau, de préférence, le matériau de la base de données matériau étant identique au matériau à usiner, l'usinage étant analysé par l'unité d'analyse et les résultats d'analyse étant transmis à l'unité centrale.

Les résultats de l'analyse sont soit communiqués vers des moyens de modélisation permettant d'extraire des paramètre physique ou d'intéraction lumière matière propre au matériau à usiner. Les moyens de modélisation permettant de recevoir des informations concenrant les caractéristiques du dispositif d'usinage. Les paramètres déterminés par les moyens de modélisation sont alors des paramètres d'usinage qui sont communiqués à la base de données matériaux afin de l'enrichir. Lorsque le matériau à usiner est connu dans la base de données, il est alors possible de poursuivre le procédé d'usinage et en particulier vers l'étape proposant une recherche de paramètre manuel (cette invention) ou automatisé.

Lorsque les résultats d'analyse sont communiqués vers l'unité centrale, l'unité centrale du système d'usinage ayant accès aux caractéristiques du système d'usinage permettent de générer des informations relatives au matériau usiné et de les enregistrer ou de mettre à jour la base de donnée matériau.

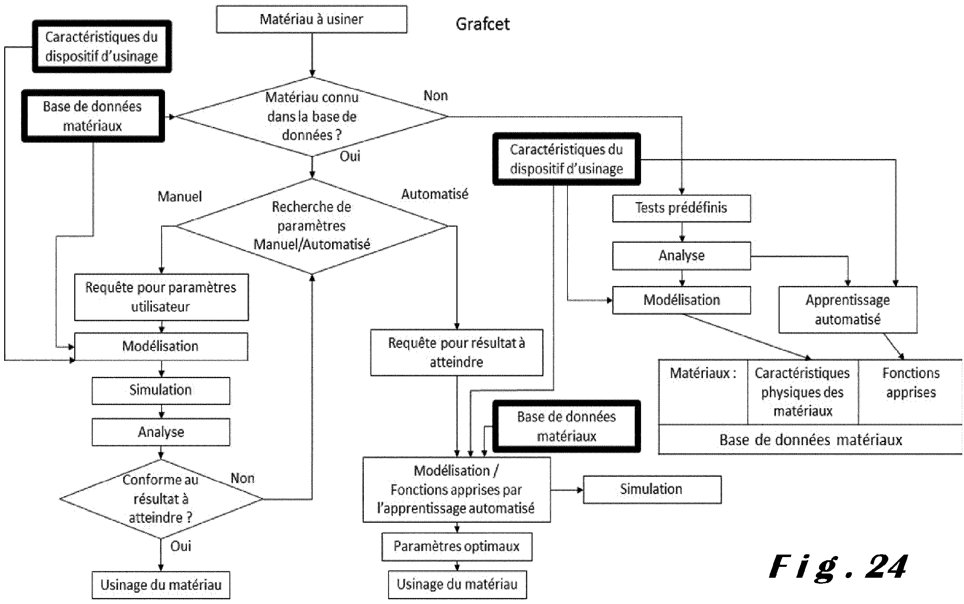

Le mode de réalisation préféré décrit au paragraphe précédent est représenté en Figure 24. Ainsi une même base données permet de regrouper pour un même matériau, les caractériqtiques physiques des matériaux ainsi que les informations relatives au système d'usinage laser de sorte à former une base de donnée d'apprentissage pour la mise en place d'un algorithme d'apprentissage automatique. Le fonctionnement de l'organigramme décrit pour la figure 23 s'applique à la figure 24 mutatis mutandis.

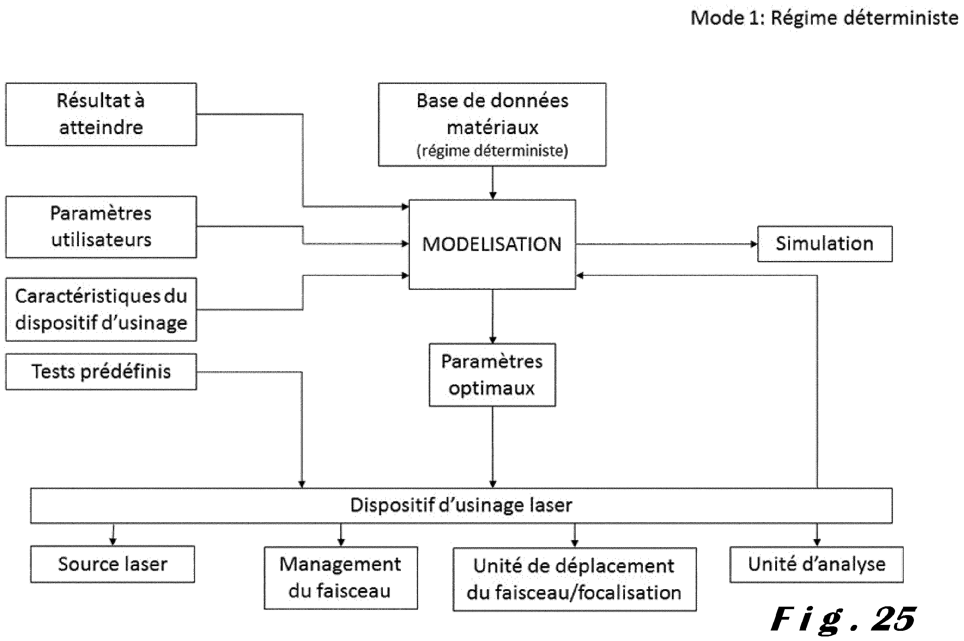

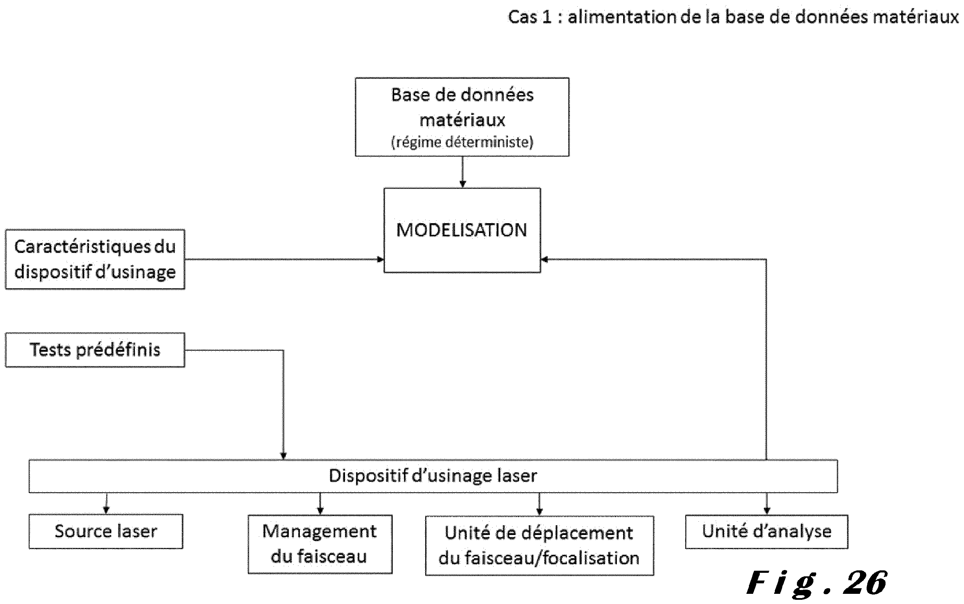

La figure 25 montre un mode de réalisation de l'invention permettant la détermination des paramètres d'usinage optimaux selon un régime déterministe pour un système d'usinage laser. En particulier, ce mode de réalisation est basé principalement sur l'utilisation d'algorithme connus tels que décrit par l'invention. Ce mode de réalisation permet également la simulation d'ablations qui seraient obtenues pour des paramètres laser obtenus par les algorithmes de l'invention ou définis par un utilisateur. Cette figure décrit les modes de réalisation détaillés en Figure 26 à 28, ces modes découlent des organigramme représentés en Figure 23 et 24.

La figure 26 montre un mode de réalisation de l'invention permettant l'alimentation de la base de données matériaux avec des caractéristiques physiques de matériaux, par exemple dans le cas ou un test prédéfini à été usiné et pour lequel les résultats sont communiqués aux moyens de modélisation tel que décrit pour les figures 23 et 24. La flèche reliant la base de données matériaux aux moyens de modélisation peut être interprétée dans un sens ou dans l'autre. Ce mode de réalisation a pour but la détermination et l'enregistrement de paramètres expérimentaux dans une base de donnée. À partir d'un usinage réalisé par un dispositif d'usinage laser, les résultats de cet usinage sont communiqués à une unité centrale qui permet un traitement des données expérimentales afin d'en extraire des paramètres physique de matériaux.

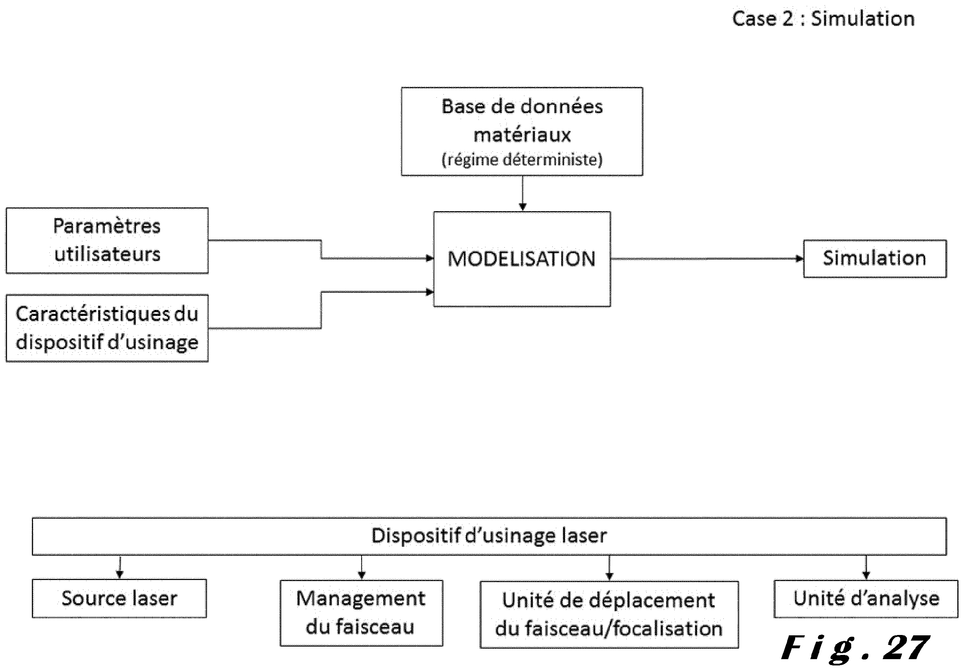

La figure 27 montre un mode de réalisation de l'invention permettant la simulation sans forcément nécessiter l'utilisation d'un dispositif d'usinage laser. Des caractéristique physique de matériaux préalablement enregistré dans la base de donnée matériau permet une simulation des résultats qu'il serait possible d'obtenir pour un usinage selon des paramètres utilisateurs et des caractéristiques du dispositif d'usinage.

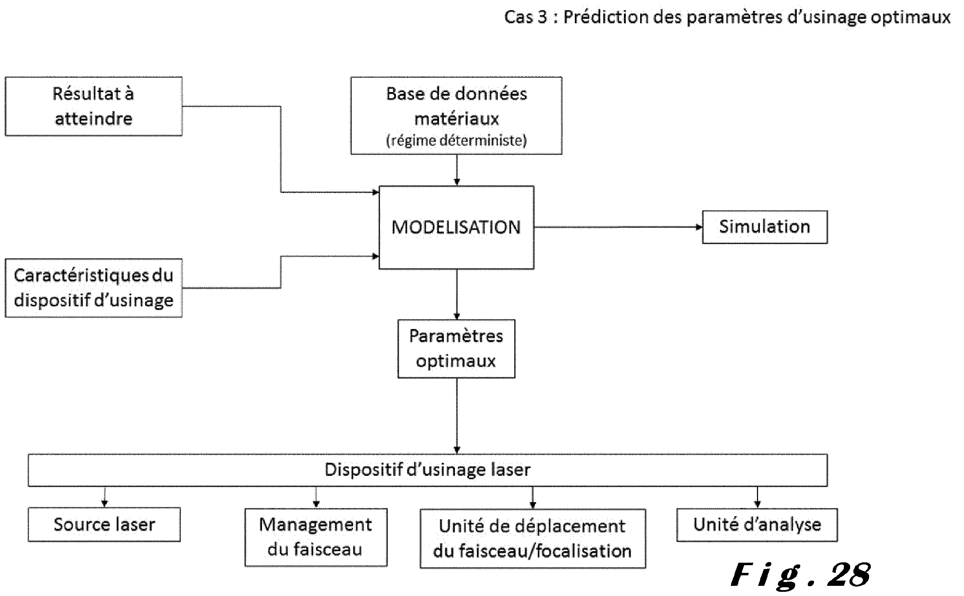

La figure 28 montre un mode de réalisation de l'invention permettant la détermination des paramètres d'usinage optimaux à partir des résultats à atteindre, des caractéristique du dispositif d'usinage laser ainsi que d'une base de données comprenant des caractérisitques physiques des matériaux, par exemple observés et enregistrés dans la base de données matériaux lors de précédents usinages.

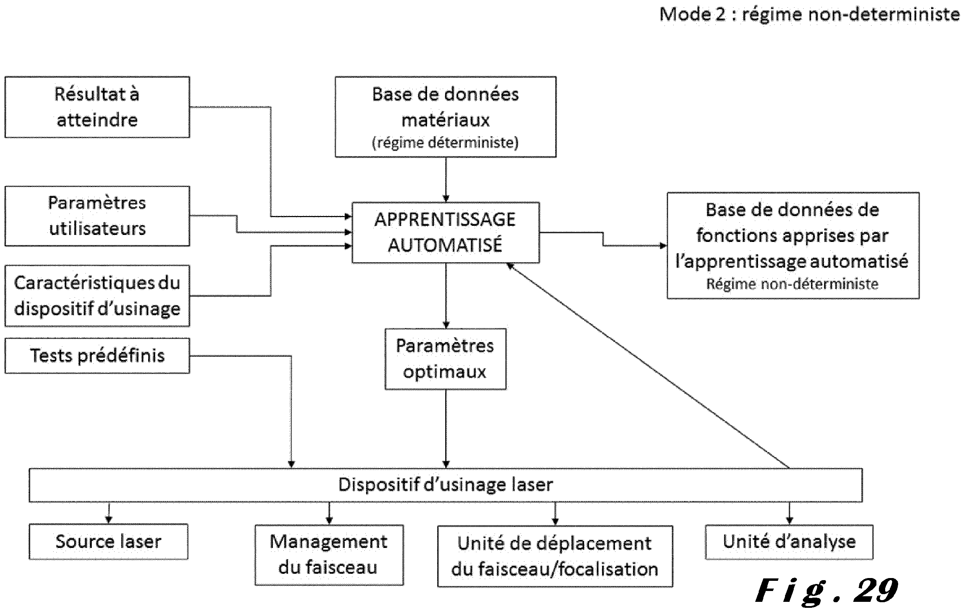

La figure 29 montre un mode de réalisation de l'invention et en particulier un mode de réalisation basé sur des moyens d'apprentissage automatisé permettant de prendre en compte des caractéristiques physiques de matériaux ou des fonctions apprises par l'apprentissage automatisé. Une fonction apprise est le résultat de l'apprentissage d'une algorithme d'apprentissage lui-même compris dans une fonction d'apprentissage. Ces informations étant de préférence stockées dans une base de données ou dans plusieurs bases de données. Ce mode de réalisation est préférentiellement basé sur un régime de détermination des paramètre optimaux non-déterministe, c'est-à-dire n'utilisant pas nécessairement les moyens de modélisation comprenant un algorithme définisannt des fonctions déterministes.

De préférence, le mode de réalisation détaillé en Figure 29 comprend une fonction d'apprentissage dont les fonctions apprises sont stockées dans une base de données. Ce mode de réalisation permet à la méthode de l'invention d'apprendre et d'affiner les paramètre optimaux sur la base d'expériences et d'observations passées. Par exemple des expériences menées sur d'autres dispositifs d'usinage laser sont pris en compte dans l'apprentissage de l'algorithme permettant la détermination de paramètre d'usinage optimaux. Ce mode de réalisation permet également la réalisation d'une expérience spécifique destinée à recueillir des données expérimentales dans le but d'obtenir des paramètre d'usinage optimaux pour un usinage cible. Par exemple des tests prédéfinis sont disponibles dans le système d'usinage laser de l'invention et sont applicables lorsqu'il est jugé nécessaire d'obtenir un usinage avec une haute-fidélité par rapport à un usinage cible.

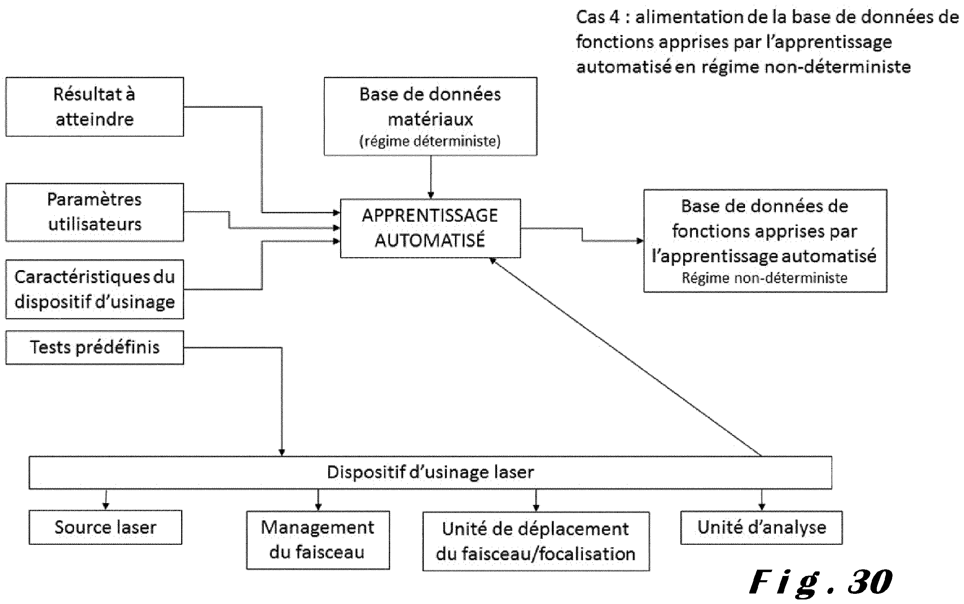

La figure 30 montre un mode de réalisation particulier de la Figure 29 permettant l'apprentissage automatisé et l'enregistrement des fonctions d'apprentissage sous la forme de focntions apprises. La figure 30 représente l'alimentation de la base de données de fonctions apprises par l'apprentissage automatisé en régime non-déterministe. De préférence, ce mode de réalisation met en oeuvre un test d'usinage prédéfini, qui peut être démarré sur un matériau choisi. Par exemple un test d'usinage prédéfini est défini en figures 2, 3a, 6a, 6b, 7a, 7b. Ces tests permettent après caractérisation des usinages obtenus par l'uinité d'analyse, l'apprentissage automatique et la détemrination d'une fonction apprise. Les résultats de ces tests et les fonctions apprises engendrés par la prise en compte de ces tests sont alors stockés dans une base de données.

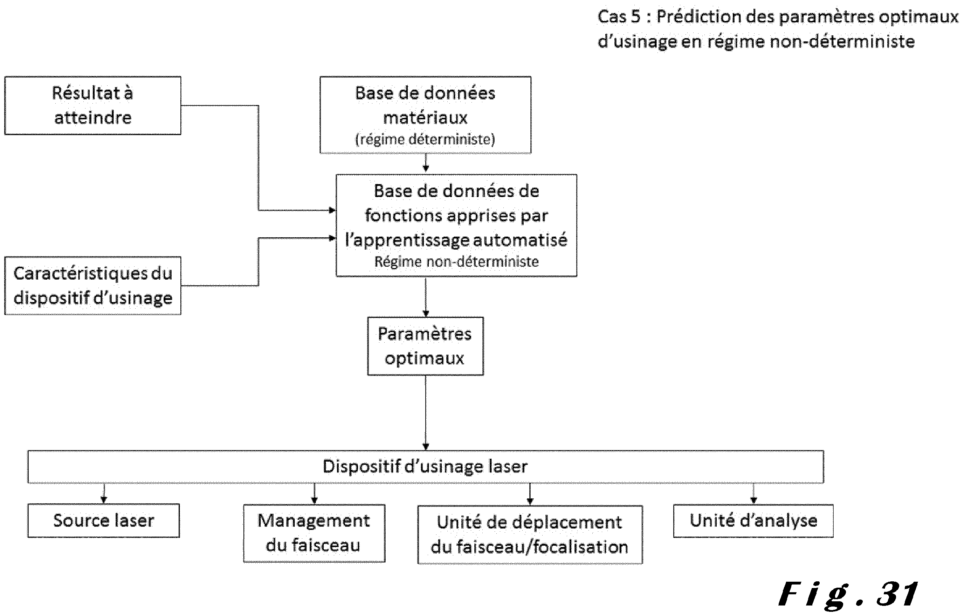

La figure 31 montre un mode de réalisation permettant l'usinage d'une pièce à partir de paramètres optimaux générés par l'unité centrale d'apprentissage ou par les moyens d'apprentissage sur la base des fonction apprise correspondant au matériau à usiner. Ce mode de réalisation permet d'obtenir des résultats d'usinage très proche de l'usinage cible désiré et de façon très rapide. La figure 31 représente la prédiction des paramètres optimaux d'usinage en régime non-déterministe.

## Revendications

1. Méthode pour la simulation d'un usinage laser par irradiation multi-impulsionnelle d'un matériau par un système d'usinage laser apte à émettre un faisceau laser d'usinage, ladite méthode étant **caractérisée par** les étapes suivantes :

    a) fournir à une unité centrale :

        - des informations relatives à l'interaction entre le faisceau laser d'usinage et le matériau à usiner comprenant :

            ○ un delta $\delta$ relatif à une profondeur de pénétration du faisceau laser d'usinage dans le matériau,
            ○ une fluence seuil $F_{th}$ relative à une densité d'énergie minimale du faisceau laser permettant un usinage,
            ○ un coefficient d'incubation S, compris entre 0 et 1, relatif à une dépendance de la fluence seuil $F_{th}$ en fonction d'un nombre d'impulsions du faisceau laser en un même point,
            ○ un indice de réfraction complexe $n + ik$,

        - des informations relatives audit système d'usinage laser comprenant :

            ○ des informations relatives à une polarisation dudit faisceau laser d'usinage,
            ○ une énergie d'impulsion dudit faisceau laser d'usinage *EP,*
            ○ un diamètre dudit faisceau laser d'usinage à un point focal *w,*
            ○ un ordre d'une gaussienne *p* dudit faisceau laser d'usinage compris entre 1 et 20,
            ○ un taux de répétition d'impulsions PRR d'impulsions n du faisceau laser d'usinage,
            ○ une longueur d'onde du faisceau laser d'usinage ;

    b) déterminer avec ladite unité centrale sur la base :

        - desdites informations relatives à l'interaction entre le faisceau laser d'usinage et le matériau à usiner, et,
        - desdites informations relatives audit système d'usinage laser,

    un profil d'usinage en deux et/ou trois dimensions correspondant à la simulation d'un usinage dudit matériau à usiner avec ledit système d'usinage laser
    la méthode comprenant en outre la prise en compte de l'augmentation de la profondeur de la surface après chaque impulsion laser consécutive.

**2.** Méthode selon la revendication précédente **caractérisée en ce que** :

- le système d'usinage laser est un système apte à émettre un faisceau d'usinage laser en déplacement selon une direction x essentiellement parallèle à une surface d'usinage dudit matériau et **en ce que**,
- l'étape a) comprend de fournir en outre les informations suivantes relatives audit système d'usinage laser :

  ◦ une distance du point de focalisation du faisceau d'usinage laser par rapport à la surface du matériau à usiner,
  ◦ une vitesse (v) de déplacement du faisceau d'usinage laser par rapport audit matériau à usiner
  ◦ un angle d'incidence du faisceau laser d'usinage par rapport à ladite surface du matériau à usiner
  ◦ un nombre de lignes à usiner
  ◦ une distance entre lesdites lignes définie précédemment
  ◦ nombre de passages du faisceau laser d'usinage sur chaque ligne à usiner.

**3.** Méthode selon la revendication 1 **caractérisée en ce que** :

- le système d'usinage laser est un système apte à émettre un faisceau d'usinage laser en rotation autour d'un axe de rotation essentiellement perpendiculaire à une surface d'usinage dudit matériau et **en ce que**,
- l'étape a) comprend de fournir en outre les informations relatives audit système d'usinage laser :

  ◦ une vitesse de rotation $\omega$ du faisceau d'usinage laser,
  ◦ une distance BFG par rapport à une surface dudit matériau à usiner pour laquelle le faisceau laser en rotation décrit une tâche fixe pour toutes les positions de faisceau d'usinage laser en rotation,
  ◦ une distance BFI par rapport à une surface dudit matériau à usiner pour laquelle le faisceau laser en rotation est focalisé,
  ◦ un angle d'incidence $\beta$ du faisceau laser d'usinage en rotation pour toutes les positions du faisceau laser en rotation par rapport à la normale à la surface du matériau
  ◦ une durée d'activation du faisceau laser d'usinage en rotation.

**4.** Méthode selon la revendication précédente **caractérisée en ce que** le faisceau laser d'usinage est un faisceau laser d'usinage en rotation autour d'un axe de rotation et d'un point de rotation situé à ladite distance BFG de ladite surface dudit matériau à usiner.

**5.** Méthode selon l'une quelconque des deux revendications précédentes **caractérisée en ce que** l'étape b) de détermination dudit profil d'usinage en deux et/ou trois dimensions comprend une étape de détermination d'un rayon de précession $r_p$ d'un usinage dudit matériau par ledit faisceau laser d'usinage en rotation par la formule suivante :

$$r_P = \left( \frac{BFG}{\cos \beta} - z \right) \tan \beta.$$

**6.** Méthode selon la revendication précédente **caractérisée en ce que** deux impulsions n successives du faisceau d'usinage en rotation, sont séparées d'une distance dx, de préférence le long d'un cercle de rayon $r_p$, et **en ce que** l'étape b) de détermination dudit profil d'usinage en deux dimensions comprend une étape de calcul d'une profondeur d'ablation $z_n$ par la formule suivante :

$$z_n = -\delta \left[ \ln \left( \frac{F_0}{F_{th}(n+NR/2)} \right) - 2\frac{n^2 dx^2}{w^2} - 2\left( \frac{(y+y_c)^2}{w^2} \right)^p \right].$$

**7.** Méthode selon l'une quelconque des revendications précédentes **caractérisée en ce que** l'étape b) de détermination dudit profil d'usinage en deux dimensions comprend une étape de détermination d'un rayon de cratère ablaté $r_c$ pour une impulsion du faisceau laser d'usinage par la formule suivante :

$$r_c = w_0 \sqrt{\ln \left( \frac{F_0}{F_{th}} \right)}.$$

EP 3 743 237 B1

**8.** Méthode selon l'une quelconque des revendications précédentes **caractérisée en ce que** ledit profil d'usinage est défini en deux dimensions selon :

- un axe y représentant une direction essentiellement parallèle à la surface du matériau à usiner, et,
- un axe z représentant une direction essentiellement perpendiculaire à la surface du matériau à usiner, l'axe z correspondant à une profondeur d'ablation $z_n$ par rapport à la surface du matériau.

**9.** Méthode selon l'une quelconque des revendications précédentes **caractérisée en ce que** lesdites informations relatives audit matériau à usiner sont issues d'une base de données matériaux, dans laquelle chaque matériau comprend les informations suivantes :

- un delta $\delta$,
- une fluence seuil $F_{th}$,
- un coefficient d'incubation S,
- un indice de réfraction complexe n + $ik$,

et **en ce que** ladite unité centrale comprend des moyens de communication pour communiquer avec ladite base de données matériaux.

**10.** Méthode selon la revendication précédente **caractérisée en ce que** ladite unité centrale comprend des moyens de simulation de sorte à pouvoir déterminer ledit profil d'usinage en deux dimensions sur la base d'informations relatives audit matériau à usiner issues de ladite base de données, et sur la base d'informations relatives audit système d'usinage laser.

**11.** Méthode selon l'une quelconque des revendications précédentes **caractérisée en ce que** la méthode comprend en outre les étapes additionnelles suivantes :

c) fournir un système d'usinage laser comprenant :

- ledit matériau à usiner ;
- ledit dispositif d'usinage laser comprenant :

  - une source laser pour émettre un faisceau d'usinage laser sur ledit matériau à usiner ;
  - une unité de contrôle pour contrôler l'émission dudit faisceau laser d'usinage issu de ladite source laser ;

- ladite unité centrale pour contrôler ladite unité de contrôle ;
- lesdits moyens de communication pour communiquer avec ladite base de données ;
- des moyens de communication permettant la communication de ladite unité centrale vers ladite base de données ;

d) usiner ledit matériau avec ladite source laser configurée avec lesdits paramètres d'usinage laser.

**12.** Méthode selon la revendication précédente **caractérisée en ce que** ledit dispositif d'usinage laser comprend en outre :

- une unité d'analyse de l'état dudit matériau à usiner connectée à ladite unité centrale pour fournir un résultat d'usinage,

et **en ce que** les étapes additionnelles suivantes sont mises en oeuvre :

e) acquérir avec ladite unité d'analyse après l'étape d), des résultats d'usinage ;
f) transmettre lesdits résultats d'usinage et lesdits paramètres d'usinage à ladite unité centrale, ladite unité centrale étant configurée pour déterminer des informations relatives au matériau à usiner ;
g) enrichir ladite base de données matériaux avec lesdites informations relatives au matériau à usiner issues de l'unité centrale.

**13.** Système d'usinage laser comprenant

27

- un dispositif d'usinage comprenant :

◦ une source laser pour émettre un faisceau d'usinage laser par irradiation multi-impulsionnelle;
◦ une unité de contrôle pour contrôler l'émission dudit faisceau d'usinage laser issu de ladite source laser ;

et étant **caractérisé par** :

- une unité centrale pour contrôler ladite unité de contrôle, l'unité centrale étant adaptée pour

◦ recevoir des informations relatives à l'interaction entre le faisceau laser d'usinage et le matériau à usiner comprenant :

◦ un delta $\delta$ relatif à une profondeur de pénétration du faisceau laser d'usinage dans le matériau,
◦ une fluence seuil Fth relative à une densité d'énergie minimale du faisceau laser permettant un usinage,
◦ un coefficient d'incubation S, compris entre 0 et 1, relatif à une dépendance de la fluence seuil Fth en fonction d'un nombre d'impulsions du faisceau laser en un même point,
◦ un indice de réfraction complexe n + ik,

◦ recevoir des informations relatives audit système d'usinage laser comprenant :

◦ des informations relatives à une polarisation dudit faisceau laser d'usinage,
◦ une énergie d'impulsion dudit faisceau laser d'usinage Ep,
◦ un diamètre dudit faisceau laser d'usinage à un point focal w,
◦ un ordre d'une gaussienne p dudit faisceau laser d'usinage compris entre 1 et 20,
◦ un taux de répétition d'impulsions PRR d'impulsions n du faisceau laser d'usinage,
◦ une longueur d'onde du faisceau laser d'usinage ;

◦ déterminer avec ladite unité centrale sur la base :

◦ desdites informations relatives à l'interaction entre le faisceau laser d'usinage et le matériau à usiner, et,
◦ desdites informations relatives audit système d'usinage laser,
un profil d'usinage en deux et/ou trois dimensions correspondant à la simulation d'un usinage dudit matériau à usiner avec ledit système d'usinage laser, en prenant en compte l'augmentation de la profondeur de la surface après chaque impulsion laser consécutive,

◦ exécuter les étapes de la méthode selon l'une quelconque des revendications précédentes.

14. Programme d'ordinateur comprenant des instructions qui, lorsque le programme est exécuté par un ordinateur, conduisent celui-ci à mettre en oeuvre les étapes de la méthode selon l'une quelconque des revendications 1 à 12.

15. Support de données lisible par ordinateur, sur lequel est enregistré le programme d'ordinateur selon la revendication 14.

**Patentansprüche**

1. Verfahren zur Simulation einer Laserbearbeitung durch Mehrimpuls-Bestrahlung eines Materials durch ein Laserbearbeitungssystem, das geeignet ist, einen Bearbeitungslaserstrahl auszusenden, wobei das Verfahren durch die folgenden Schritte gekennzeichnet ist:

a) Bereitstellen an eine Zentraleinheit:

- Informationen bezüglich der Wechselwirkung zwischen dem Bearbeitungslaserstrahl und dem zu bearbeitenden Material, umfassend:

- ein Delta $\delta$, das sich auf eine Eindringtiefe des Bearbeitungslaserstrahls in das Material bezieht,
- eine Schwellenfluenz $F_{th}$, die sich auf eine Mindestenergiedichte des Laserstrahls bezieht, die eine Bearbeitung ermöglicht,

- einen Inkubationskoeffizienten S, im Bereich zwischen 0 und 1, der sich auf eine Abhängigkeit der Schwellenfluenz $F_{th}$ in Abhängigkeit von einer Anzahl von Impulsen des Laserstrahls an einem einzigen Punkt bezieht,
- einen komplexen Brechungsindex $n + ik$,

- Informationen bezüglich des Laserbearbeitungssystems, umfassend:

- Informationen bezüglich einer Polarisation des Bearbeitungslaserstrahls,
- eine Impulsenergie des Bearbeitungslaserstrahls $E_p$,
- einen Durchmesser des Bearbeitungslaserstrahls an einem Brennpunkt w,
- eine Ordnung einer Gaußschen $p$ des Bearbeitungslaserstrahls im Bereich zwischen 1 und 20,
- eine Impulswiederholungsrate $PRR$ von Impulsen n des Bearbeitungslaserstrahls,
- eine Wellenlänge des Bearbeitungslaserstrahls;

b) Bestimmen mit der zentralen Einheit auf der Grundlage:

- der Informationen bezüglich der Wechselwirkung zwischen dem Bearbeitungslaserstrahl und dem zu bearbeitenden Material, und
- der Informationen bezüglich des Laserbearbeitungssystems, eines zwei- und/oder dreidimensionalen Bearbeitungsprofils, das der Simulation einer Bearbeitung des zu bearbeitenden Materials mit dem Laserbearbeitungssystem entspricht, wobei das Verfahren weiter die Berücksichtigung der Zunahme der Tiefe der Oberfläche nach jedem aufeinanderfolgenden Laserimpuls umfasst.

2.  Verfahren nach dem vorstehenden Anspruch, **dadurch gekennzeichnet, dass**:

- das Laserbearbeitungssystem ein System ist, das geeignet ist, einen Laserbearbeitungsstrahl bei Bewegung in einer Richtung x auszusenden, die im Wesentlichen parallel zu einer Bearbeitungsoberfläche des Materials ist, und dass
- der Schritt a) weiter das Bereitstellen folgender Informationen bezüglich des Laserbearbeitungssystems umfasst:

- ein Abstand des Fokussierpunkts des Laserbearbeitungsstrahls in Bezug auf die Oberfläche des zu bearbeitenden Materials,
- eine Bewegungsgeschwindigkeit (v) des Laserbearbeitungsstrahls in Bezug auf das zu bearbeitende Material
- einen Einfallswinkel des Bearbeitungslaserstrahls in Bezug auf die Oberfläche des zu bearbeitenden Materials
- eine Anzahl von zu bearbeitenden Linien
- einen zuvor definierten Abstand zwischen den Linien
- Anzahl der Durchläufe des Bearbeitungslaserstrahls auf jeder zu bearbeitenden Linie.

3.  Verfahren nach Anspruch 1, **dadurch gekennzeichnet, dass**:

- das Laserbearbeitungssystem ein System ist, das geeignet ist, einen Laserbearbeitungsstrahl in Rotation um eine Rotationsachse auszusenden, die im Wesentlichen senkrecht zu einer Bearbeitungsoberfläche des Materials ist, und dass
- Schritt a) weiter das Bereitstellen der Informationen bezüglich des Laserbearbeitungssystems umfasst:

- einer Rotationsgeschwindigkeit $\omega$ des Laserbearbeitungsstrahls,
- einen Abstand BFG in Bezug auf eine Oberfläche des zu bearbeitenden Materials, für die der Rotationslaserstrahl eine feste Aufgabe für alle Positionen des Rotationsbearbeitungslaserstrahls beschreibt,
- einen Abstand BFI in Bezug auf eine Oberfläche des zu bearbeitenden Materials, für die der Rotationslaserstrahl fokussiert wird,
- einen Einfallswinkel $\beta$ des Rotationsbearbeitungslaserstrahls für alle Positionen des Rotationslaserstrahls in Bezug auf die Normale zur Oberfläche des Materials
- eine Aktivierungsdauer des Rotationsbearbeitungslaserstrahls.

4.  Verfahren nach dem vorstehenden Anspruch, **dadurch gekennzeichnet, dass** der Bearbeitungslaserstrahl ein Rotationsbearbeitungslaserstrahl um eine Rotationsachse und einen Rotationspunkt ist, der sich in dem Abstand BFG von der Oberfläche des zu bearbeitenden Materials befindet.

5. Verfahren nach einem der zwei vorstehenden Ansprüche, **dadurch gekennzeichnet, dass** der Schritt b) des Bestimmens des zwei- und/oder dreidimensionalen Bearbeitungsprofils einen Schritt des Bestimmens eines Präzessionsradius $r_p$ einer Bearbeitung des Materials durch den Rotationsbearbeitungslaserstrahl durch die folgende Formel umfasst:

$$r_P = \left(\frac{BFG}{\cos\beta} - z\right)\tan\beta.$$

6. Verfahren nach dem vorstehenden Anspruch, **dadurch gekennzeichnet, dass** zwei aufeinanderfolgende Impulse n des Rotationsbearbeitungsstrahls um einen Abstand dx voneinander getrennt sind, vorzugsweise entlang eines Radiuskreises $r_p$, und dass der Schritt b) des Bestimmens des zweidimensionalen Bearbeitungsprofils einen Schritt des Berechnens einer Ablationstiefe $z_n$ durch die folgende Formel umfasst:

$$z_n = -\delta\left[\ln\left(\frac{F_o}{F_{th}(n + NR/2)}\right) - 2\frac{n^2 dx^2}{w^2} - 2\left(\frac{(y + y_c)^2}{w^2}\right)^p\right].$$

7. Verfahren nach einem der vorstehenden Ansprüche, **dadurch gekennzeichnet, dass** der Schritt b) des Bestimmens des zweidimensionalen Bearbeitungsprofils einen Schritt des Bestimmens eines ablatierten Kraterradius $r_c$ für einen Impuls des Bearbeitungslaserstrahls durch die folgende Formel umfasst:

$$r_c = w_0\sqrt{\ln\left(\frac{F_o}{F_{th}}\right)}$$

8. Verfahren nach einem der vorstehenden Ansprüche, **dadurch gekennzeichnet, dass** das Bearbeitungsprofil zweidimensional definiert ist gemäß:

- einer y-Achse, die eine Richtung darstellt, die im Wesentlichen parallel zu der Oberfläche des zu bearbeitenden Materials verläuft, und,
- einer z-Achse, die eine Richtung darstellt, die im Wesentlichen senkrecht zu der Oberfläche des zu bearbeitenden Materials verläuft, wobei die z-Achse einer Ablationstiefe $z_n$ in Bezug auf die Oberfläche des Materials entspricht.

9. Verfahren nach einem der vorstehenden Ansprüche, **dadurch gekennzeichnet, dass** die Informationen bezüglich des zu bearbeitenden Materials aus einer Materialdatenbank stammen, in der jedes Material die folgenden Informationen umfasst:

- ein Delta $\delta$,
- eine Schwellenfluenz $F_{th}$,
- einen Inkubationskoeffizienten S,
- einen komplexen Brechungsindex $n + ik$,

und dass die Zentraleinheit Kommunikationsmittel umfasst, um mit der Materialdatenbank zu kommunizieren.

10. Verfahren nach dem vorstehenden Anspruch, **dadurch gekennzeichnet, dass** die Zentraleinheit Simulationsmittel umfasst, so dass das zweidimensionale Bearbeitungsprofil auf der Grundlage von Informationen bezüglich des zu bearbeitenden Materials, die aus der Datenbank stammen, und auf der Grundlage von Informationen bezüglich des Laserbearbeitungssystems bestimmt werden kann.

11. Verfahren nach einem der vorstehenden Ansprüche, **dadurch gekennzeichnet, dass** das Verfahren weiter die folgenden zusätzlichen Schritte umfasst:

c) Bereitstellen eines Laserbearbeitungssystems, umfassend:

- das zu bearbeitende Material;
- die Laserbearbeitungsvorrichtung, umfassend:

- eine Laserquelle zum Aussenden eines Laserbearbeitungsstrahls auf das zu bearbeitende Material;
- eine Steuereinheit zum Steuern der Aussendung des von der Laserquelle ausgehenden Bearbeitungslaserstrahls;
- die zentrale Einheit, um die Steuereinheit zu steuern;
- die Kommunikationsmittel, um mit der Datenbank zu kommunizieren;
- Kommunikationsmittel, die die Kommunikation von der Zentraleinheit zur Datenbank ermöglichen;

d) Bearbeiten des Materials mit der Laserquelle, die mit den Laserbearbeitungsparametern konfiguriert ist.

12. Verfahren nach dem vorstehenden Anspruch, **dadurch gekennzeichnet, dass** die Laserbearbeitungsvorrichtung weiter umfasst:

- eine Einheit zur Analyse des Zustands des zu bearbeitenden Materials, die mit der Zentraleinheit verbunden ist, um ein Bearbeitungsergebnis bereitzustellen,

und dadurch, dass die folgenden zusätzlichen Schritte durchgeführt werden:

e) Erfassen von Bearbeitungsergebnissen mit der Analyseeinheit nach Schritt d);
f) Übertragen der Bearbeitungsergebnisse und der Bearbeitungsparameter an die Zentraleinheit, wobei die Zentraleinheit konfiguriert ist, um Informationen bezüglich des zu bearbeitenden Materials zu bestimmen;
g) Erweitern der Materialdatenbank mit den von der Zentraleinheit stammenden Informationen bezüglich des zu bearbeitenden Materials.

13. Laserbearbeitungssystem, umfassend

- eine Bearbeitungsvorrichtung, umfassend:

- eine Laserquelle zum Aussenden eines Laserbearbeitungsstrahls durch Mehrimpuls-Bestrahlung;
- eine Steuereinheit zum Steuern der Aussendung des von der Laserquelle ausgehenden Laserbearbeitungsstrahls;

und **gekennzeichnet durch**:

- eine Zentraleinheit zum Steuern der Steuereinheit, wobei die Zentraleinheit geeignet ist zum

- Empfangen von Informationen bezüglich der Wechselwirkung zwischen dem Bearbeitungslaserstrahl und dem zu bearbeitenden Material, umfassend:

- ein Delta $\delta$, das sich auf eine Eindringtiefe des Bearbeitungslaserstrahls in das Material bezieht,
- eine Schwellenfluenz Fth, die sich auf eine Mindestenergiedichte des Laserstrahls bezieht, die eine Bearbeitung ermöglicht,
- einen Inkubationskoeffizienten S, im Bereich zwischen 0 und 1, der sich auf eine Abhängigkeit der Schwellenfluenz Fth in Abhängigkeit von einer Anzahl von Impulsen des Laserstrahls an einem einzigen Punkt bezieht,
- einen komplexen Brechungsindex $n + ik$,

- Empfangen von Informationen bezüglich des Laserbearbeitungssystems, umfassend:

- Informationen bezüglich einer Polarisation des Bearbeitungslaserstrahls,
- eine Impulsenergie des Bearbeitungslaserstrahls Ep,
- einen Durchmesser des Bearbeitungslaserstrahls an einem Brennpunkt w,
- eine Ordnung einer Gaußschen p des Bearbeitungslaserstrahls im Bereich zwischen 1 und 20,
- eine Impulswiederholungsrate PRR von Impulsen n des Bearbeitungslaserstrahls,

- eine Wellenlänge des Bearbeitungslaserstrahls;

- Bestimmen mit der zentralen Einheit auf der Grundlage:

- der Informationen bezüglich der Wechselwirkung zwischen dem Bearbeitungslaserstrahl und dem zu bearbeitenden Material, und
- der Informationen bezüglich des Laserbearbeitungssystems, ein zwei- und/oder dreidimensionales Bearbeitungsprofil, das der Simulation einer Bearbeitung des zu bearbeitenden Materials mit dem Laserbearbeitungssystem unter Berücksichtigung der Zunahme der Tiefe der Oberfläche nach jedem aufeinanderfolgenden Laserimpuls entspricht,

- Ausführen der Schritte des Verfahrens nach einem der vorstehenden Ansprüche.

14. Computerprogramm, das Anweisungen umfasst, die, wenn das Programm von einem Computer ausgeführt wird, diesen dazu veranlassen, die Schritte des Verfahrens nach einem der Ansprüche 1 bis 12 auszuführen.

15. Computerlesbarer Datenträger, auf dem das Computerprogramm nach Anspruch 14 gespeichert ist.


**Claims**

1. A method for simulating a laser machining using multi-pulse irradiation of a material by a laser machining system capable of emitting a machining laser beam, said method being **characterized by** the following steps:

   a) providing a central unit with:

   - information relating to the interaction between the machining laser beam and the material to be machined comprising:

     ∘ a delta $\delta$ relative to a penetration depth of the machining laser beam in the material,
     ∘ a threshold fluence $F_{th}$ relative to a minimum energy density of the laser beam allowing a machining,
     ∘ an incubation coefficient S, between 0 and 1, relating to a dependence of the threshold fluence $F_{th}$ in function of a number of pulses of the laser beam at a single point,
     ∘ a complex refractive index $n + ik$,

   - information relating to said laser machining system comprising:

     ∘ information relating to a polarization of said machining laser beam,
     ∘ a pulse energy of said machining laser beam $E_P$,
     ∘ a diameter of said machining laser beam at a focal point $w$,
     ∘ an order of a Gaussian $p$ of said machining laser beam between 1 and 20,
     ∘ a pulse repetition rate $PRR$ of pulses $n$ of the machining laser beam,
     ∘ a wavelength of the machining laser beam;

   b) determining with said central unit on the basis of:

   - said information relating to the interaction between the machining laser beam and the material to be machined, and,
   - said information relating to said laser machining system,

   a machining profile in two and/or three dimensions corresponding to the simulation of a machining of said material to be machined with said laser machining system
   the method further comprising taking into account the increase in surface depth after each consecutive laser pulse.

2. The method according to the preceding claim **characterised in that**:

   - the laser machining system is a system capable of emitting a laser machining beam moving in a direction x substantially parallel to a machining surface of said material, and **in that**,
- the step (a) further comprises providing the following information relating to said laser machining system:

  ◦ a distance of the focus point of the laser machining beam with respect to the surface of the material to be machined,
  ◦ a speed (v) of movement of the laser machining beam with respect to said material to be machined
  ◦ an angle of incidence of the machining laser beam with respect to said surface of the material to be machined
  ◦ a number of lines to be machined
  ◦ a distance between said lines previously defined
  ◦ number of passes of the machining laser beam on each line to be machined.

3. The method according to claim 1 **characterised in that**:

  - the laser machining system is a system capable of emitting a laser machining beam in rotation about an axis of rotation substantially perpendicular to a machining surface of said material, and **in that**,
  - the step (a) further comprises providing information relating to said laser machining system:

    ◦ a rotational speed $\omega$ of the laser machining beam,
    ◦ a distance BFG with respect to a surface of said material to be machined for which the rotating laser beam describes a fixed spot for all rotating laser machining beam positions,
    ◦ a distance BFI with respect to a surface of said material to be machined at which the rotating laser beam is focused,
    ◦ an angle of incidence $\beta$ of the rotating machining laser beam for all positions of the rotating laser beam with respect to the normal to the surface of the material
    ◦ an activation time of the rotating machining laser beam.

4. The method according to the preceding claim **characterised in that** the machining laser beam is a machining laser beam in rotation about an axis of rotation and a point of rotation located at said distance BFG from said surface of said material to be machined.

5. The method according to any of the two preceding claims **characterised in that** step b) of determining said machining profile in two and/or three dimensions comprises a step of determining a precession radius $r_p$ of a machining of said material by said rotating machining laser beam by the following formula:

$$r_P = \left(\frac{BFG}{\cos\beta} - z\right)\tan\beta.$$

6. The method according to the preceding claim **characterised in that** two successive pulses $n$ of the rotating machining beam are separated by a distance $dx$, preferably along a circle having a radius $r_p$, and **in that** step b) of determining said machining profile in two dimensions comprises a step of calculating an ablation depth $z_n$ by the following formula:

$$z_n = -\delta\left[\ln\left(\frac{F_0}{F_{th}(n+NR/2)}\right) - 2\frac{n^2 dx^2}{w^2} - 2\left(\frac{(y+y_c)^2}{w^2}\right)^p\right].$$

7. The method according any one of the preceding claims **characterised in that** step b) of determining said machining profile in two dimensions comprises a step of determining an ablated crater radius $r_c$ for a pulse of the machining laser beam by the following formula:

$$r_c = w_0\sqrt{\ln\left(\frac{F_0}{F_{th}}\right)}.$$

8. The method according to any one of the preceding claims **characterised in that** said machining profile is defined in two dimensions according to:

  - an axis y representing a direction substantially parallel to the surface of the material to be machined, and,

- an axis z representing a direction substantially perpendicular to the surface of the material to be machined, the axis z corresponding to an ablation depth $z_n$ with respect to the surface of the material.

9. The method according to any one of the preceding claims **characterised in that** said information relating to said material to be machined is derived from a material database, wherein each material comprises the following information:

  ○ a delta $\delta$,
  ○ a threshold fluence Fth,
  ○ an incubation coefficient S,
  ○ a complex refractive index n + ik,

and **in that** said central unit comprises communication means for communicating with said material database.

10. The method according to the preceding claim **characterised in that** said central unit comprises simulation means so as to be able to determine said machining profile in two dimensions on the basis of information relating to said material to be machined from said database, and on the basis of information relating to said laser machining system.

11. The method according to any one of the preceding claims **characterised in that** the method further comprises the following additional steps:

  c) providing a laser machining system comprising:

    - said material to be machined;
    - said laser machining device comprising:

      ○ a laser source for emitting a laser machining beam onto said material to be machined;
      ○ a control unit for controlling the emission of said machining laser beam from said laser source;

    - said central unit for controlling said control unit;
    - said communication means for communicating with said database;
    - communication means for communication from said central unit to said database;

  d) machining said material with said laser source configured with said laser machining parameters.

12. A method according to the preceding claim **characterised in that** said laser machining device further comprises:

  ○ an analysis unit of the state of said material to be machined connected to said central unit to provide a machining result,

and **in that** the following additional steps are implemented:

  e) acquiring with said analysis unit after step d), machining results;
  f) transmitting said machining results and said machining parameters to said central unit, said central unit being configured to determine information relating to the material to be machined;
  g) enriching said material database with said information relating to the material to be machined from said central unit.

13. A laser machining system comrprising

  - a laser machining device comprising:

    ○ a laser source for emitting a laser machining beam using multi-pulse irradiation;
    ○ a control unit for controlling the emission of said machining laser beam from said laser source;

and being **characterised in that**:

  - a central unit for controlling said control unit, the central unit beign capapble of

○ receiving information relating to the interaction between the machining laser beam and the material to be machined comprising:

  ○ a delta δ relative to a penetration depth of the machining laser beam in the material,
  ○ a threshold fluence $F_{th}$ relative to a minimum energy density of the laser beam allowing a machining,
  ○ an incubation coefficient S, between 0 and 1, relating to a dependence of the threshold fluence $F_{th}$ in function of a number of pulses of the laser beam at a single point,
  ○ a complex refractive index *n + ik,*

○ receiving information relating to said laser machining system comprising:

  ○ information relating to a polarization of said machining laser beam,
  ○ a pulse energy of said machining laser beam $E_P$,
  ○ a diameter of said machining laser beam at a focal point w,
  ○ an order of a Gaussian *p* of said machining laser beam between 1 and 20,
  ○ a pulse repetition rate *PRR* of pulses n of the machining laser beam,
  ○ a wavelength of the machining laser beam;

○ determining with said central unit on the basis of:

  ○ said information relating to the interaction between the machining laser beam and the material to be machined, and,
  ○ said information relating to said laser machining system,

a machining profile in two and/or three dimensions corresponding to the simulation of a machining of said material to be machined with said laser machining system, by taking into account the increase in surface depth after each consecutive laser pulse,
○ executing the step of the method according to any of the preceding claims.

14. A computer program comprising instructions that, when the program is executed by a computer, leads the latter to implement the step of the method according to claims 1 to 12.

15. A computer-readable data medium on which the computer program according to claim 14 is recorded.

*Fig.1*

*Fig. 2*

*Fig.3a*

*Fig.3b*

*Fig.3c*

*Fig. 4a*

steel
$\omega_0 = 12.5\mu m$
$F = 3 \text{ J/cm}^2$
$V = 50\text{mm/s}$
$PRR = 200 \text{ khz}$

*Fig. 4b*

$$Fig.5$$

**F i g . 6a**

**F i g . 6b**

50 70 90     ...     mm/s

**Fig. 7a**

45 46 47     ...     %P

**Fig. 7b**

**Fig. 7c**

Fig. 7d

Fig. 8a

*Fig. 8b*

*Fig. 9*

Steel, n = 0.9+2.25i

Fig. 10

Fig. 11

- PRR = 250 kHz, v = 50 mm/s

*Fig. 12*

- PRR = 250 kHz, F = 10.82 J/cm²
- δ = 34 nm (constant)

*Fig. 13*

*F i g . 14a*

*F i g . 14b*

*F i g . 15a*    *F i g . 15b*    *F i g . 15c*

**F i g . 16a**

**F i g . 16b**

Fig. 17a

Fig. 17b

*F i g . 18*

**Fig. 19a**

**Fig. 19b**

*F i g . 20a*

*F i g . 20b*

*F i g . 20c*

BFG = 0 µm
BFI = -400 µm

50 µm

***Fig. 21a***

***Fig. 21b***

BFG = -100 µm
BFI = -500 µm

50 µm

***Fig. 21c***

***Fig. 21d***

EP 3 743 237 B1

Fig. 22b

Fig. 22a

Fig. 23

EP 3 743 237 B1

Grafcet

Matériau à usiner

Matériau connu dans la base de données ?

Non

Oui

Caractéristiques du dispositif d'usinage

Base de données matériaux

Recherche de paramètres Manuel/Automatisé

Automatisé

Requête pour résultat à atteindre

Base de données matériaux

Modélisation / Fonctions apprises par l'apprentissage automatisé

Simulation

Paramètres optimaux

Usinage du matériau

Caractéristiques du dispositif d'usinage

Tests prédéfinis

Analyse

Modélisation

Apprentissage automatisé

Fonctions apprises

Matériaux : Caractéristiques physiques des matériaux

Base de données matériaux

Manuel

Requête pour paramètres utilisateur

Modélisation

Simulation

Analyse

Conforme au résultat à atteindre ?

Non

Oui

Usinage du matériau

*Fig. 24*

Mode 1: Régime déterministe

*Fig. 25*

Base de données matériaux
(régime déterministe)

MODELISATION

Caractéristiques du dispositif d'usinage

Tests prédéfinis

Dispositif d'usinage laser

Source laser

Management du faisceau

Unité de déplacement du faisceau/focalisation

Unité d'analyse

*F i g . 26*

EP 3 743 237 B1

**Fig. 27**

EP 3 743 237 B1

Cas 3 : Prédiction des paramètres d'usinage optimaux

| Résultat à atteindre |

| Base de données matériaux (régime déterministe) |

| Caractéristiques du dispositif d'usinage |

| MODELISATION |

| Simulation |

| Paramètres optimaux |

| Dispositif d'usinage laser |

| Source laser | | Management du faisceau | | Unité de déplacement du faisceau/focalisation | | Unité d'analyse |

*Fig. 28*

EP 3 743 237 B1

Mode 2 : régime non-deterministe

**Résultat à atteindre**

**Base de données matériaux**
(régime déterministe)

**Paramètres utilisateurs**

**APPRENTISSAGE AUTOMATISÉ**

**Base de données de fonctions apprises par l'apprentissage automatisé**
Régime non-déterministe

**Caractéristiques du dispositif d'usinage**

**Tests prédéfinis**

**Paramètres optimaux**

**Dispositif d'usinage laser**

**Source laser**

**Management du faisceau**

**Unité de déplacement du faisceau/focalisation**

**Unité d'analyse**

*F i g . 29*

EP 3 743 237 B1

Cas 4 : alimentation de la base de données de
fonctions apprises par l'apprentissage
automatisé en régime non-déterministe

| Résultat à atteindre |

| Base de données matériaux (régime déterministe) |

| Paramètres utilisateurs |

| Caractéristiques du dispositif d'usinage |

| Tests prédéfinis |

| APPRENTISSAGE AUTOMATISÉ |

| Base de données de fonctions apprises par l'apprentissage automatisé Régime non-déterministe |

| Dispositif d'usinage laser |

| Source laser |

| Management du faisceau |

| Unité de déplacement du faisceau/focalisation |

| Unité d'analyse |

*Fig. 30*

EP 3 743 237 B1

Cas 5 : Prédiction des paramètres optimaux
d'usinage en régime non-déterministe

```
┌──────────────┐         ┌──────────────────┐
│  Résultat à  │         │  Base de données │
│  atteindre   │         │     matériaux    │
└──────────────┘         │(régime déterministe)│
                         └──────────────────┘
                                  │
                         ┌──────────────────────┐
                         │  Base de données de  │
                         │  fonctions apprises par │
                         │ l'apprentissage automatisé │
┌──────────────────┐     │  Régime non-déterministe │
│ Caractéristiques du │   └──────────────────────┘
│ dispositif d'usinage │            │
└──────────────────┘     ┌──────────────┐
                         │  Paramètres  │
                         │   optimaux   │
                         └──────────────┘
                                  │
┌────────────────────────────────────────────────────────┐
│              Dispositif d'usinage laser                 │
└────────────────────────────────────────────────────────┘
    │              │                │                │
┌──────────┐ ┌──────────────┐ ┌──────────────────┐ ┌──────────────┐
│ Source   │ │ Management   │ │ Unité de déplacement │ │ Unité d'analyse │
│ laser    │ │ du faisceau  │ │ du faisceau/focalisation │ └──────────────┘
└──────────┘ └──────────────┘ └──────────────────┘
```

*F i g . 31*

**EP 3 743 237 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2015113302 A
- US 2016078156 A
- WO 2011083087 A